# EUROPEAN PATENT APPLICATION

(11) **EP 4 624 295 A1**
(43) Date of publication of application: **01.10.2025**
(21) Application number: 23911297.2
(22) Date of filing: 21.09.2023
(51) Int. Cl.: B61B 13/00, B61B 3/02, B65G 1/04, G05D 1/43

(54) **CEILING-TRAVELLING-VEHICLE STOPPING DEVICE AND TRAVELLING-VEHICLE SYSTEM**

(30) Priority: 28.12.2022 JP 2022212488
(71) Applicant: Murata Machinery, Ltd., Kyoto-shi, Kyoto 601-8326 (JP)
(72) Inventor: ITO Yasuhisa, Inuyama-shi, Aichi 484-8502 (JP)
(74) Representative: Hoffmann Eitle
(86) International application number: PCT/JP2023/034345
(87) International publication number: WO 2024/142513

(57) **Abstract**

An overhead traveling vehicle stopping device is attached to rails provided on a ceiling and stops an overhead traveling vehicle traveling along travel routes constituted by the rails. The overhead traveling vehicle stopping device includes an engagement part engageable with the rails, and a body including an elongated member extending downwardly from the engagement part. The body includes at least one first detection target portion detected by obstacle sensors of an overhead traveling vehicle traveling toward the body from a transverse direction intersecting the elongated member, and second detection target portions detected by the obstacle sensors of the overhead traveling vehicle traveling toward the body from another direction intersecting the elongated member and different from the transverse direction.

## Description

### Technical Field

The present disclosure relates to an overhead traveling vehicle stopping device and a traveling vehicle system.

### Background Art

There is known an overhead traveling vehicle stopping device that is attached to rails provided on a ceiling and stops an overhead traveling vehicle traveling along travel routes constituted by the rails. As this type of technology, for example, Patent Literature 1 describes a stopping device that stops an overhead traveling vehicle by being detected by an obstacle sensor of the overhead traveling vehicle. A stop plate as an example of the stopping device includes an engagement part engageable with rails, and an operation rod extending downwardly from the engagement part and setting the engagement part to either an engaged state or a non-engaged state with respect to the rails.

### Citation List

### Patent Literature

Patent Literature 1: Japanese Unexamined Patent Publication No. 2015-131502

### Summary of Invention

### Technical Problem

In the above-described stop plate, in a case where the overhead traveling vehicle attempts to enter a certain region from one direction along a travel route, passage in the region is prohibited. However, in a case where the overhead traveling vehicle attempts to enter a certain region from a plurality of directions, the entry of the overhead traveling vehicle cannot be appropriately prohibited.

The present disclosure describes an overhead traveling vehicle stopping device and a traveling vehicle system capable of appropriately prohibiting an overhead traveling vehicle from entering from a plurality of directions into a region where passage is to be prohibited.

### Solution to Problem

(1) An overhead traveling vehicle stopping device according to one aspect of the present disclosure is a stopping device attached to rails provided on a ceiling and configured to stop an overhead traveling vehicle traveling along travel routes constituted by the rails, the stopping device includes an engagement part configured to be engageable with the rail, and a body that includes an elongated member configured to extend downwardly from the engagement part. The body includes at least one first detection target portion configured to be detected by obstacle sensors of the overhead traveling vehicle traveling toward the body from a transverse direction intersecting the elongated member, and a second detection target portion configured to be detected by the obstacle sensor of the overhead traveling vehicle traveling toward the body from another direction intersecting the elongated member and different from the transverse direction.
   According to this overhead traveling vehicle stopping device, the engagement part is engaged with the rails. Thus, in a case where the overhead traveling vehicle travels along the transverse direction of the body, the first detection target portion is detected by the obstacle sensor of the overhead traveling vehicle to stop the traveling, and in a case where the overhead traveling vehicle travels along another direction of the body, the second detection target portion is detected by the obstacle sensor of the overhead traveling vehicle to stop the traveling. As described above, it is possible to appropriately prohibit the overhead traveling vehicle from entering from two different directions (a plurality of directions) without preparing and attaching a plurality of stopping devices.
(2) In the overhead traveling vehicle stopping device according to the above (1), the transverse direction and the other direction may be orthogonal to each other in a horizontal plane. In this case, in a case where travel routes in two directions orthogonal to each other are set by the rails, it is possible to appropriately prohibit the overhead traveling vehicle from entering from these two directions. The overhead traveling vehicle stopping device is suitable for a grid-shaped track such as a so-called grid system.
(3) In the overhead traveling vehicle stopping device according to the above (1) or (2), the elongated member may have a rod shape, the second detection target portion may have a plate shape with the other direction as a thickness direction, and the elongated member and the first detection target portion may be accommodated within a range of a width of the second detection target portion in the transverse direction. In this case, the body can have a simple configuration. In addition, the device can be made slim in the transverse direction.
(4) In the overhead traveling vehicle stopping device according to any one of the above (1) to (3), the body may include a first push-down part configured to press down a power switch of the overhead traveling vehicle in a case where the first push-down part comes into contact with the overhead traveling vehicle approaching from the transverse direction, and a second push-down part configured to press down the power switch of the overhead traveling vehicle in a case where the second push-down part comes into contact with the overhead traveling vehicle approaching from the other direction. In this case, it is possible to forcibly stop the overhead traveling vehicle by turning off a power supply of the overhead traveling vehicle coming into contact with the body by the first push-down part or the second push-down part.
(5) In the overhead traveling vehicle stopping device according to any one of the above (1) to (4), the body may include the second detection target portion detected by the obstacle sensor of the overhead traveling vehicle traveling toward the body from one side in the other direction, and another second detection target portion detected by the obstacle sensor of the overhead traveling vehicle traveling toward the body from the other side in the other direction, and the first detection target portion may be disposed between the second detection target portion and the other second detection target portion. In this case, it is possible to appropriately prohibit the overhead traveling vehicle from entering from one side in another direction and the entry of the overhead traveling vehicle from the other side in another direction.
(6) In the overhead traveling vehicle stopping device according to any one of the above (1) to (5), the at least one first detection target portion may include two inner detection target portions, respectively, detected by the obstacle sensors of the overhead traveling vehicle traveling along two parallel inner travel routes that are the travel routes extending in the transverse direction, and two outer detection target portions, respectively, detected by the obstacle sensors of the overhead traveling vehicle traveling along two outer travel routes located on both sides of the two inner travel routes in the other direction and parallel to the two inner travel routes. In this case, in a so-called grid system, the overhead traveling vehicle stopping device can prohibit the passage of each of four parallel travel routes.
(7) In the overhead traveling vehicle stopping device according to the above (6), the body may be deformable between a deployed state where the obstacle sensors of the overhead traveling vehicle traveling along the two outer travel routes are capable of detecting the two outer detection target portions, respectively, and an accommodated state where the obstacle sensors of the overhead traveling vehicle traveling along the two outer travel routes are not capable of detecting the two outer detection target portions. In this case, it is possible to easily adjust a place where the passage of the overhead traveling vehicle is prohibited.
(8) In the overhead traveling vehicle stopping device according to the above (7), the body may include a pair of proximal arm members extending from the elongated member along a longitudinal direction that is the other direction, and a pair of distal arm members foldably connected to distal ends of the proximal arm members via hinges, the two inner detection target portions may be provided on the pair of proximal arm members, and the two outer detection target portions may be provided on the pair of distal arm members. In this case, the pair of distal arm members are folded, and thus, the device is easily deformable into the accommodated state. A compact overhead traveling vehicle stopping device is realized only by folding the overhead traveling vehicle stopping device in a Z shape in plan view.
(9) In the overhead traveling vehicle stopping device according to the above (8), each of the pair of distal arm members may rotate about the hinge in one of a clockwise direction and a counterclockwise direction in plan view, and
   in both the deployed state and the accommodated state of the body, the pair of proximal arm members and the pair of distal arm members may fall within a range of a width of the second detection target portion in the transverse direction. In this case, since rotation directions of the pair of distal arm members are the same, it is easy to deform (fold) the overhead traveling vehicle stopping device. In both the deployed state and the accommodated state, the compact overhead traveling vehicle stopping device is realized.
(10) A traveling vehicle system according to another aspect of the present disclosure includes rails that are provided on a ceiling, at least a part of the rails being disposed in a grid shape, an overhead traveling vehicle configured to travel along travel routes constituted by the rails, and the overhead traveling vehicle stopping device according to any one of claims 1 to 9 configured to stop the overhead traveling vehicle traveling along the travel route. In this traveling vehicle system, the above overhead traveling vehicle stopping device can also appropriately prohibit the overhead traveling vehicle from entering from two different directions (a plurality of directions).
(11) In the traveling vehicle system according to the above (10), the rails may include a plurality of first straight rails extending in a first direction that is a horizontal direction, and a plurality of second straight rails extending in a second direction that is a horizontal direction orthogonal to the first direction, and
   in a case where a rectangular region surrounded by a pair of the first straight rails and a pair of the second straight rails in plan view is defined as one cell,
   the at least one first detection target portion may include two inner detection target portions, respectively, detected by the obstacle sensors of the overhead traveling vehicle traveling along two parallel inner travel routes that are the travel routes passing through two central cells among four cells arranged in a line, and two outer detection target portions, respectively, detected by the obstacle sensors of the overhead traveling vehicle traveling along two outer travel routes that are the travel routes passing through two cells at both ends among the four cells and are parallel to the inner travel routes. In this case, in a so-called grid system, the overhead traveling vehicle stopping device can prohibit the passage of each of four parallel travel routes.
(12) In the traveling vehicle system according to the above (11), the body may be deformable between a deployed state where the obstacle sensors of the overhead traveling vehicle traveling along the two outer travel routes are capable of detecting the two outer detection target portions, and an accommodated state where the obstacle sensors of the overhead traveling vehicle traveling along the two outer travel routes are not capable of detecting the two outer detection target portions. In this case, it is possible to easily adjust a place where the passage of the overhead traveling vehicle is prohibited.
(13) In the traveling vehicle system according to any one of the above (10) to (12), the rails may include a plurality of straight rails, and intersection rails disposed so as to be adjacent to end portions of the straight rails in a horizontal direction with a gap therebetween, the engagement part may be engaged with a pair of the straight rails extending along a same direction and aligned so as to approach or come into contact with each other, may be capable of passing through the gap in a vertical direction, and may have a C-shape opened upward as viewed from a direction along the pair of straight rails, and may include a contact portion that comes into contact with an upper surface of each of the pair of straight rails. In this case, the engagement of the engagement part with the rails can be specifically realized in a so-called grid system.
(14) In the traveling vehicle system according to any one of the above (10) to (12), the rails may include a plurality of straight rails, and the engagement part may be engaged with a pair of the straight rails extending along a same direction and aligned so as to approach to each other, and may include an insertion part that is inserted between the pair of straight rails, and a contact portion that is connected to an upper side of the insertion part and comes into contact with an upper surface of each of the pair of straight rails. In this case, the engagement of the engagement part with the rails can be specifically realized in a so-called grid system.

### Advantageous Effects of Invention

According to the present disclosure, it is possible to appropriately prohibit the overhead traveling vehicle from entering from two different directions (a plurality of directions) without preparing and attaching a plurality of stopping devices.

### Brief Description of Drawings

FIG. 1 is a perspective view illustrating a traveling vehicle system according to an embodiment.
FIG. 2 is a side view illustrating an overhead traveling vehicle of FIG. 1.
FIG. 3 is a front view illustrating a deployed state of an overhead traveling vehicle stopping device according to the embodiment.
FIG. 4 is a sectional view illustrating an engagement part in FIG. 3.
FIG. 5 is a plan view for explaining engagement of the engagement part in FIG. 3 with a grid-shaped rail.
FIG. 6(a) is a sectional view taken along line VI-VI of FIG. 3. FIG. 6(b) is an enlarged front view illustrating a part of the overhead traveling vehicle stopping device of FIG. 3.
FIG. 7 is a front view illustrating an accommodated state of the overhead traveling vehicle stopping device according to the embodiment.
FIG. 8(a) is a sectional view taken along line VIII-VIII in FIG. 7. FIG. 8(b) is an enlarged front view illustrating a part of the overhead traveling vehicle stopping device of FIG. 7.
FIG. 9(a) is a left side view illustrating the deployed state of the overhead traveling vehicle stopping device. FIG. 9(b) is a left side view illustrating the accommodated state of the overhead traveling vehicle stopping device.
FIG. 10(a) is a plan view of a grid-shaped rail for explaining the deployed state of the overhead traveling vehicle stopping device. FIG. 10(b) is a plan view of a grid-shaped rail for explaining the accommodated state of the overhead traveling vehicle stopping device.
FIG. 11(a) is a plan view of a grid-shaped rail for explaining a usage example of the overhead traveling vehicle stopping device. FIG. 11(b) is a plan view of a grid-shaped rail for explaining another usage example of the overhead traveling vehicle stopping device. FIG. 11(c) is a plan view of a grid-shaped rail for explaining still another usage example of the overhead traveling vehicle stopping device.
FIG. 12(a) is a plan view illustrating an example of a prohibition line that prohibits entry. FIG. 12(b) is a plan view illustrating another example of the prohibition line that prohibits entry.
FIGS. 13(a) to 13(d) are plan views illustrating an example of a procedure in a case where the prohibition line is constructed.
FIG. 14 is a plan view illustrating an example of a plurality of partial lines forming the prohibition line of FIG. 12(a).
FIG. 15(a) is a plan view illustrating an example of an annular prohibition line. FIG. 15(b) is a plan view illustrating a case where one prohibited cell is provided between a pair of walls. FIG. 15(c) is a plan view illustrating two cells in which the overhead traveling vehicle stopping device is provided in the case of FIG. 15(b).
FIG. 16 is a sectional view illustrating an engagement part according to a modification.
FIG. 17(a) is a front view illustrating the engagement part in FIG. 16. FIG. 17(b) is a plan view illustrating the engagement part of FIG. 16. FIG. 17(c) is a side view illustrating the engagement part in FIG. 16.
FIGS. 18(a) and 18(b) are plan views illustrating disposition examples of the overhead traveling vehicle stopping device in a case where the prohibition line is formed in each of three cells.
FIGS. 19(a) and 19(b) are plan views illustrating a disposition example of the overhead traveling vehicle stopping device in a case where the prohibition line is formed in each of five cells.
FIGS. 20(a) and 20(b) are plan views illustrating a disposition example of the overhead traveling vehicle stopping device in a case where the prohibition line is formed in each of seven cells.

### Description of Embodiments

Hereinafter, an embodiment will be described with reference to the drawings. In the following description, the same or corresponding elements are denoted by the same references, and redundant description is omitted. In the drawings, for the sake of convenience in description, each configuration according to the embodiment is expressed by appropriately changing a scale. In some drawings, an XYZ orthogonal coordinate system is also described. Hereinafter, a description will be given assuming that one direction along a horizontal plane is an X direction (first direction), a direction orthogonal to the X direction and along a horizontal plane is a Y direction (second direction), and a vertical direction is a Z direction.

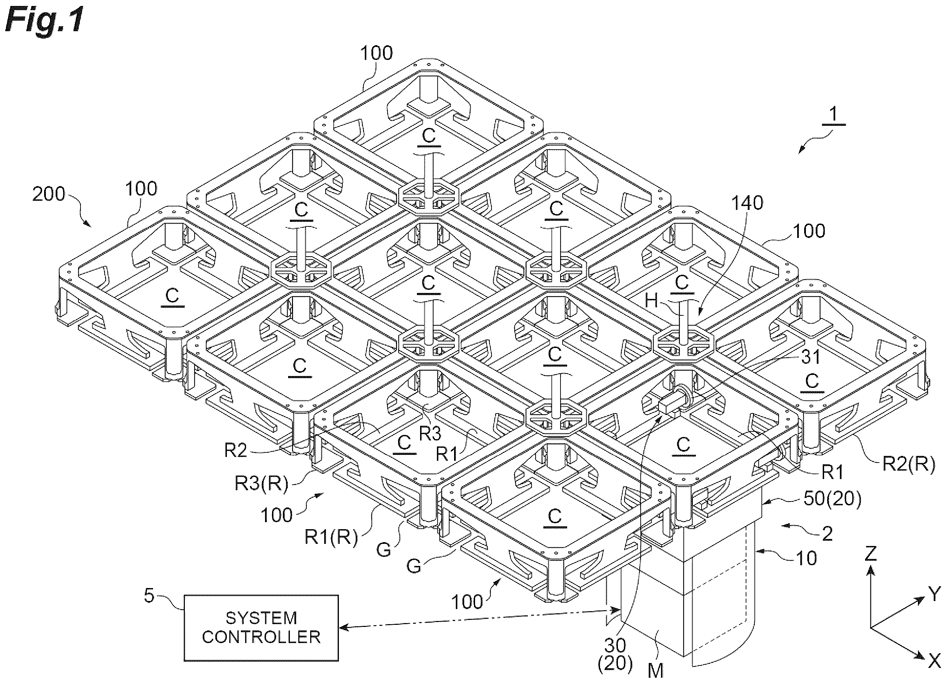

As illustrated in FIG. 1, a traveling vehicle system 1 according to the embodiment is a grid system for transporting an article M by an overhead traveling vehicle 2, for example, in a clean room of a semiconductor manufacturing factory. The traveling vehicle system 1 includes, for example, a plurality of overhead traveling vehicles 2, a system controller 5 that controls the plurality of overhead traveling vehicles 2, and a grid-shaped track R (rail) on which the plurality of overhead traveling vehicles 2 travel. The article M is, for example, a front opening unified pod (FOUP) that houses a semiconductor wafer, a reticle pod that houses a reticle, or the like. The overhead traveling vehicle 2 may be referred to as a carriage, a transfer vehicle, a transfer carriage, a traveling carriage, or the like.

The grid-shaped track R is provided on a ceiling or near a ceiling of a building such as a clean room. The grid-shaped track R extends along a horizontal direction and is formed in a grid shape in plan view. The grid-shaped track R includes a plurality of first rails R1 extending in the X direction, a plurality of second rails R2 extending in the Y direction, and intersection rails R3 disposed at portions corresponding to intersections between the first rails R1 and the second rails R2. Upper surfaces of the first rail R1, the second rail R2, and the intersection rail R3 constitute a flat and horizontal traveling surface. The first rail R1 constitutes a first straight rail (straight rail), and the second rail R2 constitutes a second straight rail (straight rail).

In the grid-shaped track R, the plurality of first rails R1 extend continuously at intervals in the X direction, and the plurality of second rails R2 extend continuously at intervals in the Y direction. On an X direction line, two intersection rails R3 are disposed between one first rail R1 and another first rail R1. On a Y direction line, two intersection rails R3 are disposed between one second rail R2 and another second rail R2. The plurality of first rails R1, the plurality of second rails R2, and the plurality of intersection rails R3 are disposed with predetermined gaps G therebetween. That is, the intersection rail R3 is disposed so as to be adjacent to end portions of the first and second rails R1 and R2 in the horizontal direction with the gaps G therebetween.

In the present embodiment, the grid-shaped track R is constructed by arranging a plurality of rail units 100 in the X direction and the Y direction. Each of the plurality of rail units 100 has a rectangular shape in plan view. Each rail unit 100 includes a pair of first rails R1 and R1 constituting opposite sides of the rectangle, a pair of second rails R2 and R2 constituting different opposite sides of the rectangle, and four intersection rails R3 constituting four corners of the rectangle. In each rail unit 100, the first rails R1, the second rails R2, and the intersection rails R3 are supported by a support wall, a support column, and the like.

The plurality of rail units 100 are connected to each other by connecting members 140, and are suspended from a ceiling (not illustrated) or the like by ae plurality of suspension members H. In each rail unit 100, rectangular regions (grid) each having a rectangular shape in plan view surrounded by the pair of first rails R1 and R1 facing each other and the pair of second rails R2 and R2 facing each other constitutes one cell C.

The shape and range (layout) of the grid-shaped track R can be appropriately adjusted or changed by arraying the plurality of rail units 100 in any layout. The grid-shaped track R constitutes a travel route on which the overhead traveling vehicle 2 travels. The travel route is set to pass through (connect) a plurality of cells C in plan view. In the grid system, a plurality of travel routes corresponding to the number of cells C can be set.

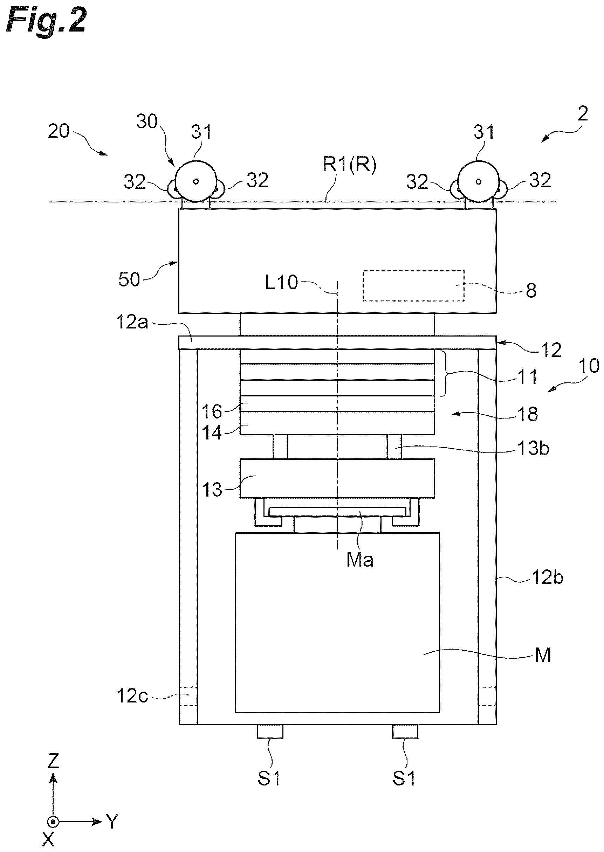

As illustrated in FIGS. 1 and 2, the overhead traveling vehicle 2 is connected to be able to communicate with the system controller 5 via a communication system (not illustrated). The overhead traveling vehicle 2 travels along a travel route constituted by the grid-shaped track R. The overhead traveling vehicle 2 includes a traveling carriage 20 which travels on the grid-shaped track R, and a body 10 which is attached to a lower portion of the traveling carriage 20 and is turnable with respect to the traveling carriage 20. The traveling carriage 20 includes a carriage unit 50 disposed below the grid-shaped track R, and traveling units 30 provided at positions of four corners on the carriage unit 50 in plan view. The carriage unit 50 is suspended on the grid-shaped track R via the traveling unit 30. A carriage controller (control unit) 8 is provided inside the carriage unit 50.

The body 10 is turnable about a rotation axis L10 in the Z direction with respect to the carriage unit 50. The body 10 includes a body frame 12 formed in, for example, a cylindrical shape. The body frame 12 includes a disk-shaped top plate portion 12a and a cylindrical frame 12b hanging down from a peripheral edge portion of the top plate portion 12a. The body frame 12 has a shape in which a lower surface is opened. The body 10 includes a transfer device 18 disposed inside the body frame 12.

The transfer device 18 moves in the horizontal direction with respect to the traveling unit 30 to transfer the article M to and from, for example, a load port (load stage). The transfer device 18 is rotatable about the rotation axis L10. The transfer device 18 includes an article holding unit 13 that holds the article M, a lifting drive unit 14 that lifts and lowers the article holding unit 13 in the Z direction, and a horizontally extracting mechanism 11 that slides and moves the lifting drive unit 14 in the horizontal direction. A rotation drive unit 16 that drives to rotate the lifting drive unit 14 about a rotation axis along the Z direction with respect to the horizontally extracting mechanism 11 is provided between the horizontally extracting mechanism 11 and the lifting drive unit 14.

The traveling unit 30 includes four traveling wheels 31. Two auxiliary wheels 32 are provided in each of the traveling wheels 31. The traveling wheels 31 are driven to be rotated by a driving force of a traveling drive motor (not illustrated). The traveling wheel 31 rolls on the grid-shaped track R. The auxiliary wheels 32 are disposed in front of and behind the traveling wheels 31 in a traveling direction one by one. The four traveling wheels 31 are steered by a wheel turning mechanism (not illustrated). As a result, the traveling direction of the overhead traveling vehicle 2 can be switched between the X direction and the Y direction.

The carriage controller 8 integrally controls the overhead traveling vehicle 2. The carriage controller 8 is provided, for example, in the carriage unit 50. The carriage controller 8 controls the traveling of the overhead traveling vehicle 2 based on a transport command. The carriage controller 8 controls a transfer operation of the overhead traveling vehicle 2 based on the transport command. The system controller 5 selects any one of the plurality of overhead traveling vehicles 2 capable of transporting the article M, and assigns the transport command to the selected overhead traveling vehicle 2. The transport command includes a travel command for causing the overhead traveling vehicle 2 to travel to the load port, and a loading command for the article M disposed in the load port or an unloading command for the held article M to the load port.

As illustrated in FIG. 2, the overhead traveling vehicle 2 includes obstacle sensors S1. The overhead traveling vehicle 2 is configured to be able to stop the traveling of the overhead traveling vehicle 2 based on a detection result of the obstacle sensor S1. The obstacle sensor S1 detects an obstacle located ahead in the traveling direction of the overhead traveling vehicle 2. The obstacle sensors S1 are provided a lower portion of the cylindrical frame 12b. The obstacle sensor S1 is, for example, an optical sensor that detects an obstacle by emitting detection light. An emission region of the detection light may be linear, band-shaped, or radial. The obstacle sensor S1 may be a sensor capable of detecting a distance from the obstacle sensor S1. The detection result of the obstacle sensor S1 is acquired by the carriage controller 8. In a case where the obstacle sensor S1 detects an obstacle whose distance to the overhead traveling vehicle 2 is equal to or less than a prescribed distance, the carriage controller 8 stops the traveling of the overhead traveling vehicle 2.

The overhead traveling vehicle 2 has a tape switch (power switch) 12c. The tape switch 12c is a contact sensor that detects contact with the overhead traveling vehicle 2. The tape switch 12c outputs a signal, for example, when contact with a first dedicated pusher (push-down part) 81 to be described later or the like is detected. In a case where the contact with the first dedicated pusher 81 or the like is detected by the tape switch 12c, the overhead traveling vehicle 2 stops traveling, for example, by disconnecting a power supply.

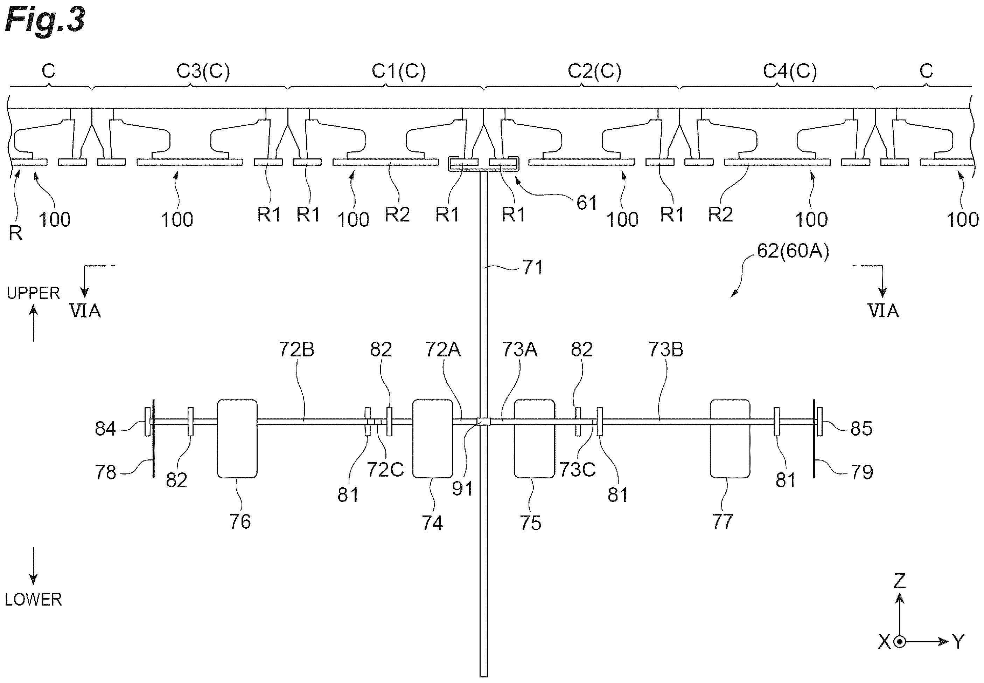

As illustrated in FIG. 3, the traveling vehicle system 1 of the present embodiment includes an overhead traveling vehicle stopping device 60. Note that, traveling control is performed by the carriage controller 8 or the system controller 5 such that each overhead traveling vehicle 2 does not travel in a predetermined region (prohibited region) of the grid-shaped track R, that is, does not enter the region. The overhead traveling vehicle stopping device 60 of the present embodiment is installed to further ensure safety under such traveling control. Hereinafter, the overhead traveling vehicle stopping device 60 will be specifically described.

The overhead traveling vehicle stopping device 60 is a stopping device that stops the overhead traveling vehicle 2 traveling along the travel route. The overhead traveling vehicle stopping device 60 is detachably attached to the grid-shaped track R. The overhead traveling vehicle stopping device 60 includes an engagement part 61 and a body 62. Note that, in the following description, the vertical direction is referred to as an "upper-lower direction", one horizontal direction is referred to as a "left-right direction", and another horizontal direction perpendicular to the left-right direction is referred to as a "front-rear direction".

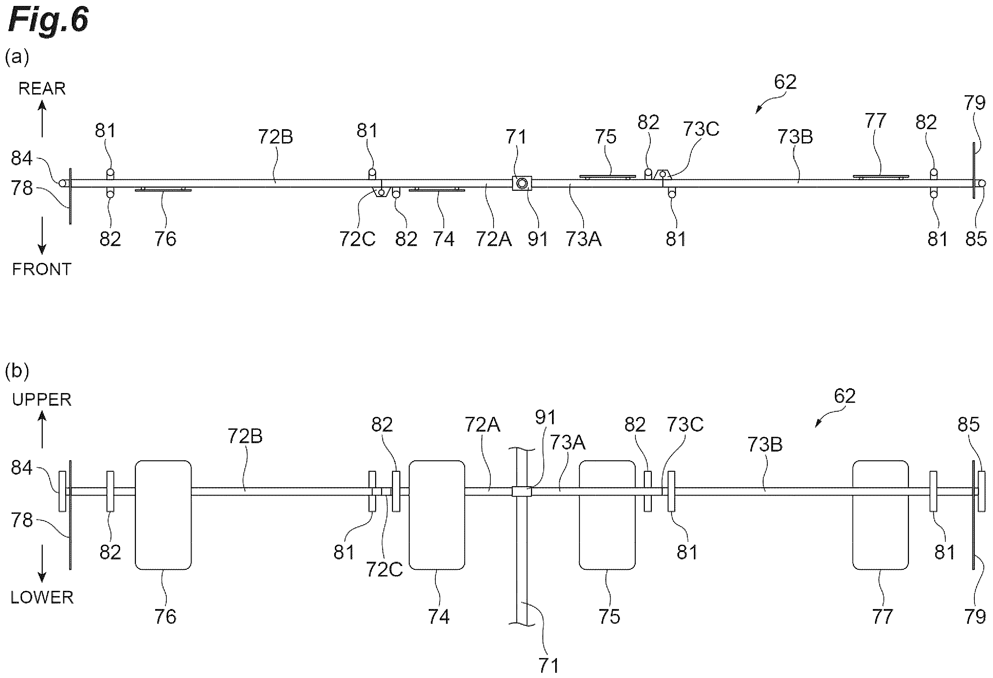

As illustrated in FIGS. 3 and 6(a), the body 62 of the overhead traveling vehicle stopping device 60 has a longitudinal direction (another direction) in which the entire body 62 extends long, and a transverse direction orthogonal to the longitudinal direction and crossing the body 62. The transverse direction and the longitudinal direction are orthogonal to each other in the horizontal plane, for example. In the illustrated example, the front-rear direction, that is, the X direction corresponds to the transverse direction of the body 62, and the left-right direction, that is, the Y direction corresponds to the longitudinal direction of the body 62. A size of the body 62 in the transverse direction is smaller than a size of the body 62 in the longitudinal direction (in both a deployed state and an accommodated state to be described later). The body 62 has a flat shape that is long in the longitudinal direction and is short in the transverse direction as a whole in plan view (in both the deployed state and the accommodated state to be described later).

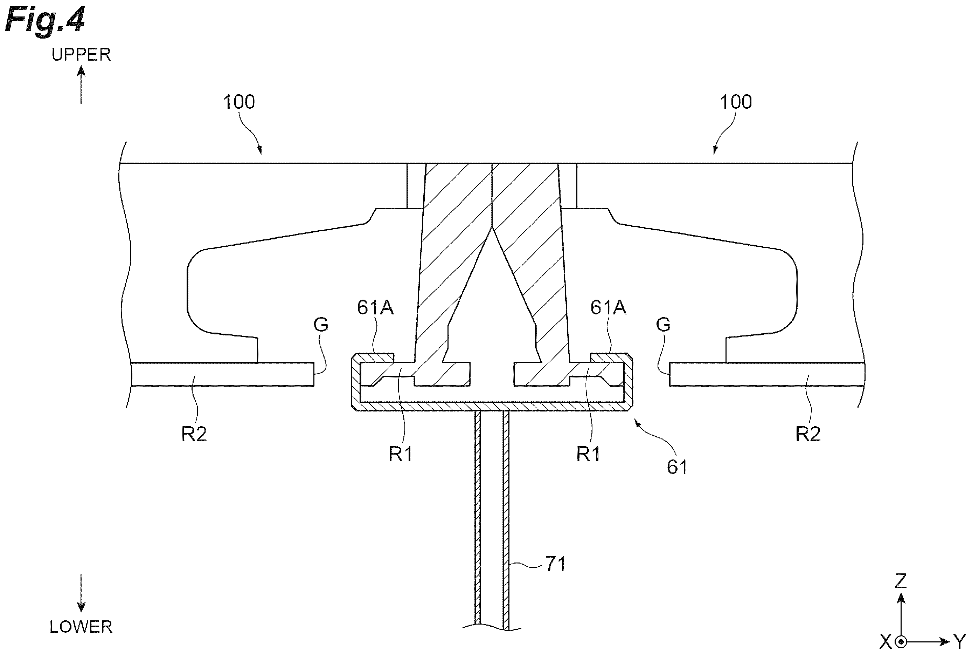

As illustrated in FIG. 3, the overhead traveling vehicle stopping device 60 may be attached to the grid-shaped track R such that the transverse direction of the body 62 coincides with the X direction (the longitudinal direction of the body 62 coincides with the Y direction), or may be attached in an orientation different from the above orientation. For example, the overhead traveling vehicle stopping device 60 may be attached to the grid-shaped track R such that the transverse direction of the body 62 coincides with the Y direction. In this case, the longitudinal direction of the body 62 coincides with the X direction. In the grid-shaped track R including the plurality of rail units 100, a configuration including a pair of parallel first rails R1 and R1 (see FIG. 4) and a configuration including a pair of parallel second rails R2 and R2 are the same except that extending directions thereof are different by 90 degrees. Accordingly, the common (one type of) overhead traveling vehicle stopping device 60 can be attached in any orientation described above. Hereinafter, in the description with reference to FIGS. 3 to 10 and FIGS. 16 to 18, an attachment structure in which the transverse direction of the body 62 coincides with the X direction will be described, but since an attachment structure in a case where the overhead traveling vehicle stopping device 60 is attached in an orientation different from this orientation is also similar, the description thereof will be omitted.

As illustrated in FIG. 4, the engagement part 61 is a member engageable with the grid-shaped track R. In the illustrated example, the engagement part 61 is engaged with a pair of first rails R1 and R1 (hereinafter, also simply referred to as a "pair of first rails R1 and R1") extending along the same X direction and aligned in the Y direction so as to approach each other. The pair of first rails R1 and R1 approaching in the Y direction are a first rail R1 included in one rail unit 100 of the pair of rail units 100 adjacent in the Y direction and a first rail R1 included in the other rail unit 100. The pair of first rails R1 and R1 may be in contact with each other in the Y direction.

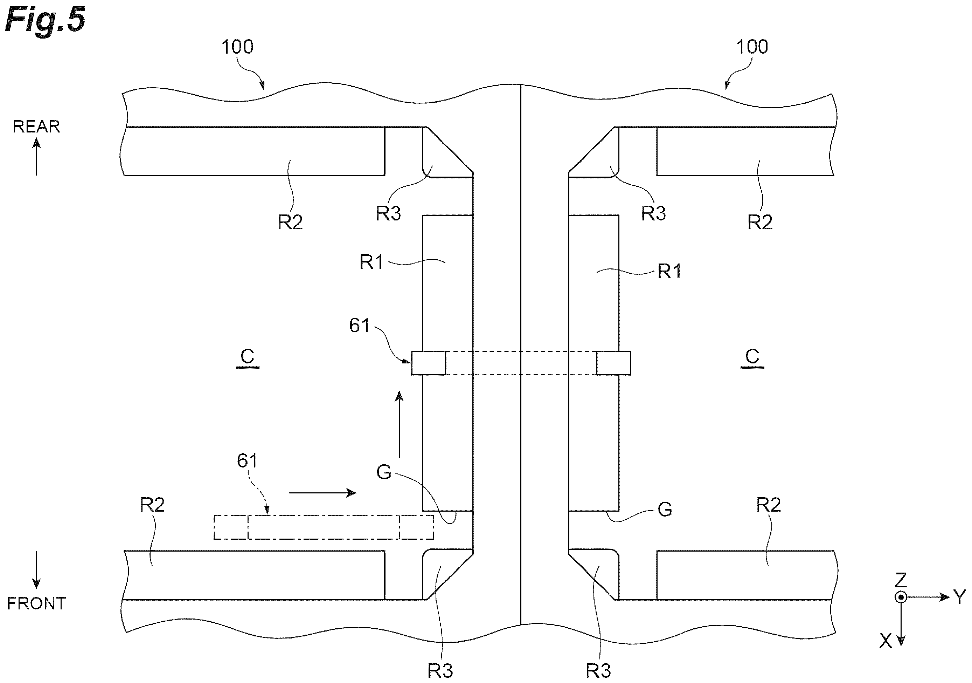

The engagement part 61 is a C-shaped hook having a C shape that opens upward as viewed from the front-rear direction along the first rail R1. The engagement part 61 has, for example, a bent plate shape formed by bending a plate material. The engagement part 61 includes a contact portion 61A that comes into contact with an outer side in a width direction on an upper surface of each of the pair of first rails R1 and R1. The contact portion 61A is constituted by an upper portion of the engagement part 61 and includes a plane coming into contact with the upper surface of each of the first rails R1. As illustrated in FIG. 5, the engagement part 61 has a width shorter than the gap G in the front-rear direction, and can pass through the gap G in the upper-lower direction. The engagement part 61 is engaged so as to be suspended from a central portion of the pair of first rails R1 and R1 in the longitudinal direction.

As illustrated in FIGS. 3, 6(a), and 6(b), the body 62 includes a pole (elongated member) 71, a first fixed beam (proximal arm member) 72A, a first movable beam (distal arm member) 72B, a second fixed beam (proximal arm member) 73A, a second movable beam (distal arm member) 73B, a first inner stopper plate (inner detection target portion or first detection target portion) 74, a second inner stopper plate (inner detection target portion or first detection target portion) 75, a first outer stopper plate (outer detection target or first detection target portion) 76, a second outer stopper plate (outer detection target portion or first detection target portion) 77, a first side stopper plate (second detection target portion) 78, and a second side stopper plate (another second detection target portion) 79.

The pole 71 has a rod shape that extends downwardly from the engagement part 61. The pole 71 is a circular tubular member whose axial direction is the upper-lower direction. The pole 71 has a length of, for example, about 2 m. An upper end of the pole 71 is fixed at a position of a center in the left-right direction and at a center in the front-rear direction on a lower surface of the engagement part 61. The axial direction of the pole 71 is orthogonal to the lower surface of the engagement part 61. The above-described transverse direction is a horizontal direction orthogonal to (intersecting) the pole 71. In addition, the longitudinal direction is a horizontal direction orthogonal to (intersecting) the pole 71 and the transverse direction.

As illustrated in FIGS. 3, 7, 8(a), and 8(b), the first fixed beam 72A, the first movable beam 72B, the second fixed beam 73A, and the second movable beam 73B have a rod shape extending from the pole 71 along the left-right direction. The first fixed beam 72A extends from the pole 71 to one side in the left-right direction. The first fixed beam 72A is connected to the pole 71, and the first movable beam 72B is connected to a distal end of the first fixed beam 72A.

The first fixed beam 72A is a circular tubular member whose axial direction is the left-right direction. The first fixed beam 72A extends from the pole 71 toward one side in the left-right direction. A proximal end of the first fixed beam 72A is fixed to the pole 71 via a connecting part 91. The first fixed beam 72A is located immediately below a first cell C1 which is the cell C formed by any one of the pair of first rails R1 and R1 with which the engagement part 61 is engaged (see FIG. 3).

The first movable beam 72B is a circular tubular member similar to the first fixed beam 72A. A proximal end of the first movable beam 72B is connected to the distal end of the first fixed beam 72A via a hinge 72C. The first movable beam 72B operates to swing with an axis along the upper-lower direction of the hinge 72C as a base axis. Specifically, the first movable beam 72B operates such that a distal end thereof moves in a counterclockwise direction toward a front side in plan view. In other words, the first movable beam 72B turns around the hinge 72C in the counterclockwise direction in plan view.

The first movable beam 72B is connected to be foldable with respect to the distal end of the first fixed beam 72A via the hinge 72C. Note that, in the following description, a state where the first movable beam 72B is opened and extends in a straight line with the first fixed beam 72A (a state where the first movable beam 72B is not folded into the first fixed beam 72A) is also referred to as an open state of the first movable beam 72B. In addition, a state where the first movable beam 72B is folded and extends in parallel with the first fixed beam 72A is also referred to as a closed state of the first movable beam 72B. In the open state, the first movable beam 72B is located immediately below a third cell C3 that is the cell C adjacent to the first cell C1 on a side away from the pole 71 in the left-right direction. The hinge 72C is not particularly limited, and for example, a torque hinge (free stop hinge) or the like may be used.

As illustrated in FIGS. 3, 7, 8(a), and 8(b), the second fixed beam 73A extends from the pole 71 to the other side in the left-right direction. The second fixed beam 73A is connected to the pole 71, and the second movable beam 73B is connected to a distal end of the second fixed beam 73A. The second fixed beam 73A is a circular tubular member whose axial direction is the left-right direction. The second fixed beam 73A extends from the pole 71 toward the other side in the left-right direction. A proximal end of the second fixed beam 73A is fixed to the pole 71 via the connecting part 91. The second fixed beam 73A is located immediately below a second cell C2 which is the cell C formed by the other of the pair of first rails R1 and R1 with which the engagement part 61 is engaged.

The second movable beam 73B is a circular tubular member similar to the second fixed beam 73A. A proximal end of the second movable beam 73B is connected to the distal end of the second fixed beam 73A via a hinge 73C. The second movable beam 73B operates to swing with an axis along the upper-lower direction of the hinge 73C as a base axis. Specifically, the second movable beam 73B operates such that a distal end thereof moves in a counterclockwise direction toward a rear side in plan view. In other words, the second movable beam 73B turns around the hinge 73C in the counterclockwise direction in plan view.

The second movable beam 73B is connected to be foldable with respect to the distal end of the second fixed beam 73A via the hinge 73C. Note that, in the following description, a state where the second movable beam 73B is opened and extends in a straight line with the second fixed beam 73A (a state where the second movable beam 73B is not folded into the second fixed beam 73A) is also referred to as an open state of the second movable beam 73B. In addition, a state where the second movable beam 73B is folded and extends in parallel with the second fixed beam 73A is also referred to as a closed state of the second movable beam 73B. In the open state, the second movable beam 73B is located immediately below a fourth cell C4 that is the cell C adjacent to the second cell C2 on a side away from the pole 71 in the left-right direction. The hinge 73C is not particularly limited, and for example, a torque hinge or the like may be used.

A fixing portion of the first fixed beam 72A with respect to the pole 71 and a fixing portion of the second fixed beam 73A with respect to the pole 71 are at an equal position, and the connecting part 91 is shared. The first fixed beam 72A and the second fixed beam 73A extend horizontally in a straight line. The first fixed beam 72A and the second fixed beam 73A are not limited to being made of separate rod-shaped members, and may be made of one rod-shaped member. Note that, the proximal end of the first fixed beam 72A and the proximal end of the second fixed beam 73A may be fixed to the pole 71 via separate connecting members.

As illustrated in FIGS. 3, 6(a), and 6(b), the first inner stopper plate 74 is provided on the first fixed beam 72A, and the second inner stopper plate 75 is provided on the second fixed beam 73A. The first outer stopper plate 76 is provided on the first movable beam 72B, and the second outer stopper plate 77 is provided on the second movable beam 73B. The inner stopper plates 74 and 75 and the outer stopper plates 76 and 77 have a rectangular flat plate shape in which a reflectance of light of the obstacle sensor S1 is a certain color or more (for example, white).

An upper end portion of the first inner stopper plate 74 is fixed to be detachable from a front side of the first fixed beam 72A with a screw or the like with the front-rear direction (transverse direction) as a thickness direction. The first inner stopper plate 74 is disposed immediately below the first cell C1. The first inner stopper plate 74 is detected by the obstacle sensor S1 of the overhead traveling vehicle 2 traveling along a first travel route which is a travel route passing through the first cell C1 in the front-rear direction. The front-rear direction corresponds to an extending direction of the first rail R1 with which the engagement part 61 is engaged. The front-rear direction corresponds to a horizontal transverse direction orthogonal to the pole 71.

The second inner stopper plate 75 is fixed to be detachable from a rear side of the second fixed beam 73A with a screw or the like with the front-rear direction as the thickness direction. The second inner stopper plate 75 is disposed at the same position as the first inner stopper plate 74 in the upper-lower direction. The second inner stopper plate 75 is disposed immediately below the second cell C2. The second inner stopper plate 75 is detected by the obstacle sensor S1 of the overhead traveling vehicle 2 traveling along a second travel route which is a travel route that is parallel to the first travel route and passes through the second cell C2 in the front-rear direction.

The first outer stopper plate 76 is fixed to be detachable from a front side of the first movable beam 72B in the open state with a screw or the like with the front-rear direction as the thickness direction. The first outer stopper plate 76 is disposed at the same position as the inner stopper plates 74 and 75 in the upper-lower direction. The first outer stopper plate 76 is disposed immediately below the third cell C3**.** The first outer stopper plate 76 is detected by the obstacle sensor S1 of the overhead traveling vehicle 2 traveling along a third travel route which is a travel route that is parallel to the first travel route and passes through the third cell C3 in the front-rear direction.

The second outer stopper plate 77 is fixed to be detachable from a rear side of the second movable beam 73B in the open state with a screw or the like with the front-rear direction as the thickness direction. The second outer stopper plate 77 is disposed at the same position as the inner stopper plates 74 and 75 in the upper-lower direction. The second outer stopper plate 77 is disposed immediately below the fourth cell C4. The second outer stopper plate 77 is detected by the obstacle sensor S1 of the overhead traveling vehicle 2 traveling along a fourth travel route which is a travel route that is parallel to the second travel route and passes through the fourth cell C4 in the front-rear direction.

Each of the first inner stopper plate 74, the second inner stopper plate 75, the first outer stopper plate 76, and the second outer stopper plate 77 is detected by the obstacle sensors S1 of the overhead traveling vehicle 2 traveling toward the body 62 from the front-rear direction (transverse direction).

The body 62 includes the first dedicated pusher (first push-down part) 81 and a first dual-purpose pusher (first push-down part) 82. The first dedicated pusher 81 and the first dual-purpose pusher 82 are members that press down the tape switch 12c of the overhead traveling vehicle 2 in a case where the first dedicated pusher 81 and the first dual-purpose pusher 82 come into contact with the overhead traveling vehicle 2. Each of the first dedicated pusher 81 and the first dual-purpose pusher 82 is a circular tubular member whose axial direction is the upper-lower direction. The first dedicated pusher 81 and the first dual-purpose pusher 82 are fixed to be detachable from the fixed beams 72A and 73A and the movable beams 72B and 73B via attachment portions. The first dedicated pusher 81 and the first dual-purpose pusher 82 are disposed at positions farther from the fixed beams 72A and 73A and the movable beams 72B and 73B than the inner stopper plates 74 and 75 and the outer stopper plates 76 and 77 in the front-rear direction.

In a case where the first movable beam 72B is in the open state, the first dedicated pusher 81 is provided on a rear side of a proximal end portion of the first movable beam 72B and a rear side of a distal end portion of the first movable beam 72B. In addition, in a case where the second movable beam 73B is in the open state, the first dedicated pusher 81 is provided on a front side of a proximal end portion of the second movable beam 73B and a front side of a distal end portion of the second movable beam 73B.

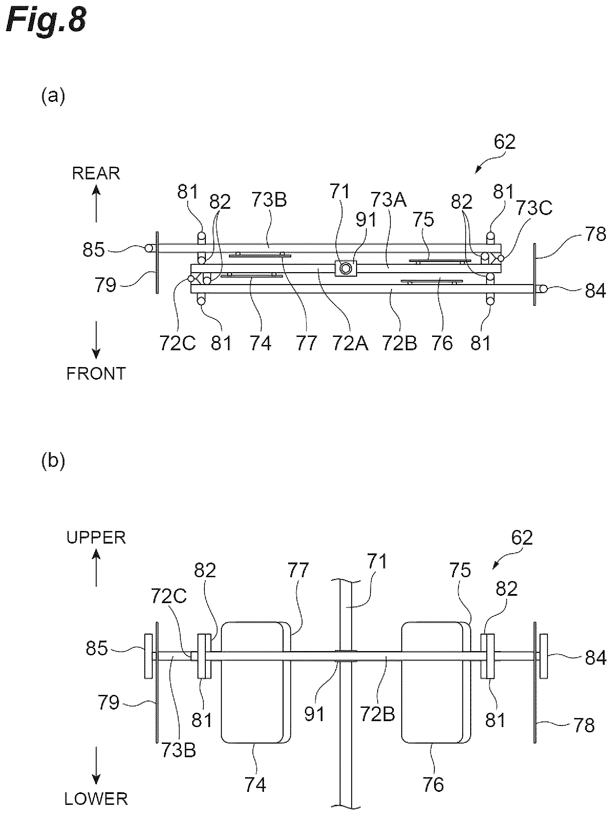

The first dual-purpose pusher 82 is provided on a front side of a distal end portion of the first fixed beam 72A and a front side of the distal end portion of the first movable beam 72B. The first dual-purpose pusher 82 functions as a stopper that prevents the first movable beam 72B in the closed state from operating until coming into contact with the first fixed beam 72A and the second fixed beam 73A (see FIG. 8(a)). The first dual-purpose pusher 82 functions as a stopper that prevents the second movable beam 73B in the closed state from operating until coming into contact with the first fixed beam 72A and the second fixed beam 73A (see FIG. 8(a)).

Each of the first dedicated pusher 81 and the first dual-purpose pusher 82 presses down the tape switch 12c of the overhead traveling vehicle 2 in a case where the first dedicated pusher 81 or the first dual-purpose pusher 82 comes into contact with the overhead traveling vehicle 2 approaching from the front-rear direction (transverse direction).

As illustrated in FIGS. 3, 6(a), and 6(b), the first side stopper plate 78 is provided at the distal end portion of the first movable beam 72B. The second side stopper plate 79 is provided at the distal end portion of the second movable beam 73B. The first side stopper plate 78 and the second side stopper plate 79 have a rectangular flat plate shape in which the reflectance of the light of the obstacle sensor S1 is a certain color or more (for example, white).

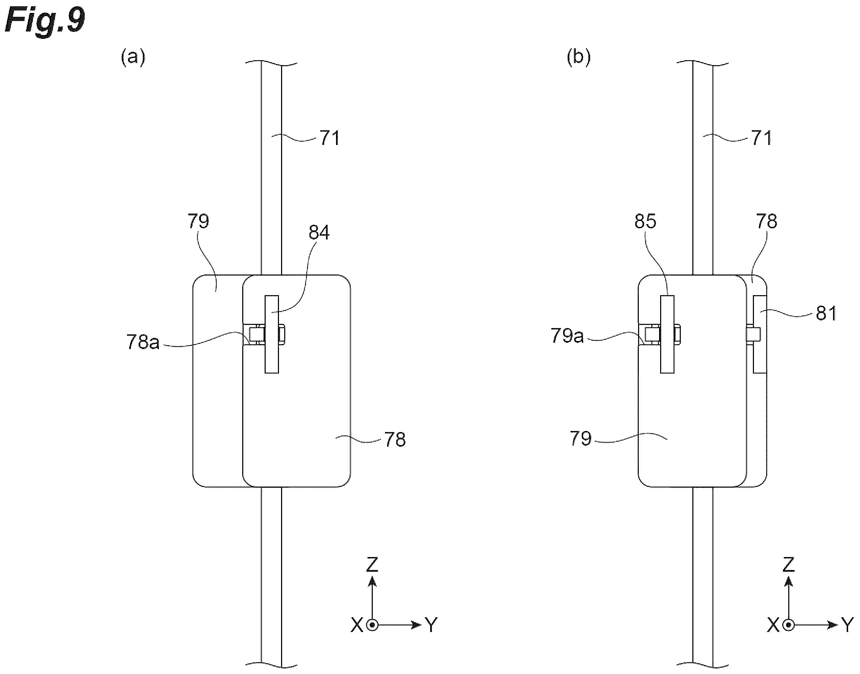

As illustrated in FIGS. 6(b) and 9(a), an upper end portion of the first side stopper plate 78 is fixed to be detachable from the distal end portion of the first movable beam 72B with a screw or the like with the left-right direction (longitudinal direction) as the thickness direction. For example, a notch 78a is formed at the upper end portion of the first side stopper plate 78, and the distal end portion of the first movable beam 72B is inserted into the notch 78a. The first side stopper plate 78 is detected by the obstacle sensor S1 of the overhead traveling vehicle 2 traveling along the travel route passing through the first cell C1 to the fourth cell C4 in the longitudinal direction.

An upper end portion of the second side stopper plate 79 is fixed to be detachable from the distal end portion of the second movable beam 73B with a screw or the like with the left-right direction as the thickness direction. For example, a notch 79a (see FIG. 9(b)) is formed at the upper end portion of the second side stopper plate 79, and the distal end portion of the second movable beam 73B is inserted into the notch 79a. The second side stopper plate 79 is detected by the obstacle sensor S1 of the overhead traveling vehicle 2 traveling along the travel route passing through the first cell C1 to the fourth cell C4 in the longitudinal direction.

The body 62 includes second pushers 84 and 85. The second pushers 84 and 85 are members that press down the tape switch 12c of the overhead traveling vehicle 2 in a case where the second pushers come into contact with the overhead traveling vehicle 2. Each of the second pushers 84 and 85 is a circular tubular member whose axial direction is the upper-lower direction. The second pushers 84 and 85 are fixed to be detachable from the distal end portions of the movable beams 72B and 73B via attachment portions. The second pusher (second push-down part) 84 attached to the distal end of the first movable beam 72B is disposed at a position farther from the distal end portion of the first movable beam 72B than the first side stopper plate 78. The second pusher (another second push-down part) 85 attached to the distal end of the second movable beam 73B is disposed at a position farther from the distal end portion of the second movable beam 73B than the second side stopper plate 79.

Each of the second pushers 84 and 85 presses down the tape switch 12c of the overhead traveling vehicle 2 in a case where each of the second pushers comes into contact with the overhead traveling vehicle 2 approaching from the left-right direction (longitudinal direction or side).

In the overhead traveling vehicle stopping device 60 having the above configuration, as illustrated in FIGS. 3, 6(a), and 6(b), the body 62 can be deformed into the deployed state (4-cell type) by bringing the first movable beam 72B into the open state where the first movable beam 72B is extended along the first fixed beam 72A without being folded and bringing the second movable beam 73B into the open state where the second movable beam 73B is extended along the second fixed beam 73A without being folded. In the deployed state, the first fixed beam 72A, the second fixed beam 73A, the first movable beam 72B, and the second movable beam 73B extend horizontally in a straight line. Rectangular surfaces of the inner stopper plates 74 and 75 and the outer stopper plates 76 and 77 are, for example, orthogonal to the transverse direction.

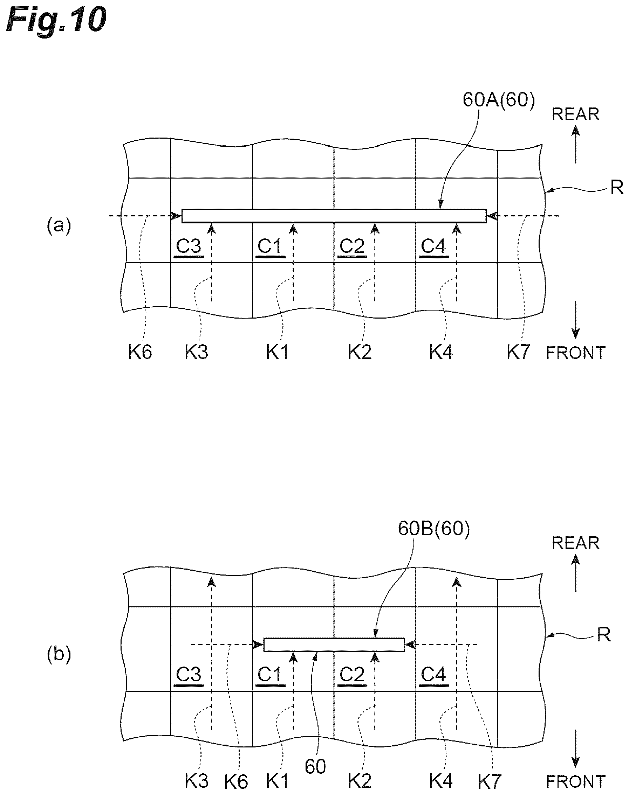

FIGS. 10(a) and 10 (b) illustrate a first travel route K1 (inner travel route) passing through the first cell C1 in the front-rear direction, a second travel route K2 (inner travel route) passing through the second cell C2 in the front-rear direction, a third travel route K3 (outer travel route) passing through the third cell C3 in the front-rear direction, and a fourth travel route K4 (outer travel route) passing through the fourth cell C4 in the front-rear direction. In addition, a first side travel route K6 and a second side travel route K7 which are orthogonal to these traveling directions and pass through the first to fourth cells C1 to C4 in the left-right direction are illustrated. In the deployed state, the inner stopper plates 74 and 75 and the outer stopper plates 76 and 77 are detected by the obstacle sensors S1 of the overhead traveling vehicle 2 traveling along the first to fourth travel routes K1 to K4 passing through the first to fourth cells C1 to C4 in the front-rear direction. As described above, the body 62 includes the inner stopper plates 74 and 75 detected by the obstacle sensors S1 of the overhead traveling vehicle 2 traveling along the first and second travel routes K1 and K2 extending in the transverse direction, and the outer stopper plates 76 and 77 detected by the obstacle sensors S1 of the overhead traveling vehicle 2 traveling along the third and fourth travel routes K3 and K4 located on both sides of the first and second travel routes K1 and K2 in the left-right direction and parallel to the first and second travel routes K1 and K2. In other words, the body 62 includes the inner stopper plates 74 and 75 detected by the obstacle sensors S1 of the overhead traveling vehicle 2 traveling along the first and second travel routes K1 and K2 passing through the two central cells C1 and C2 among the four cells C1 to C4 arranged in a line, and the outer stopper plates 76 and 77 detected by the obstacle sensors S1 of the overhead traveling vehicle 2 traveling along the third and fourth travel routes K3 and K4 passing through the two cells C3 and C4 at both ends among the four cells C1 to C4, and traveling in parallel with the first and second travel routes K1 and K2. In the deployed state, in a case where the overhead traveling vehicle 2 comes into contact with the body 62, the first dedicated pusher 81 or the first dual-purpose pusher 82 presses the tape switch 12c of the overhead traveling vehicle 2, and the overhead traveling vehicle 2 can be urgently stopped.

In the deployed state, the first side stopper plate 78 is detected by the obstacle sensor S1 of the overhead traveling vehicle 2 traveling toward the body 62 from a left side (one side in the longitudinal direction) illustrated in FIG. 3. In the deployed state, the second side stopper plate 79 is detected by the obstacle sensor S1 of the overhead traveling vehicle 2 traveling toward the body 62 from a right side (the other side in the longitudinal direction) illustrated in FIG. 3. The first side stopper plate 78 and the second side stopper plate 79 are disposed at both end portions of the body 62 in the left-right direction, and four first detection target portions such as the pole 71 and the first inner stopper plate 74 are disposed therebetween. In addition, in the deployed state, in a case where the overhead traveling vehicle 2 comes into contact with the body 62, the second pusher 84 or the second pusher 85 presses the tape switch 12c of the overhead traveling vehicle 2, and the overhead traveling vehicle 2 can be urgently stopped.

In the deployed state of the body 62, the body 62 is made compact in the front-rear direction (transverse direction). That is, as illustrated in FIG. 9(a), the first detection target portions such as the pole 71 and the first inner stopper plate 74 are accommodated within a range of widths of the first side stopper plate 78 and the second side stopper plate 79 in the transverse direction. In addition, the first fixed beam 72A, the second fixed beam 73A, the first movable beam 72B, and the second movable beam 73B fall within the range of the widths of the first side stopper plate 78 and the second side stopper plate 79 in the front-rear direction (transverse direction).

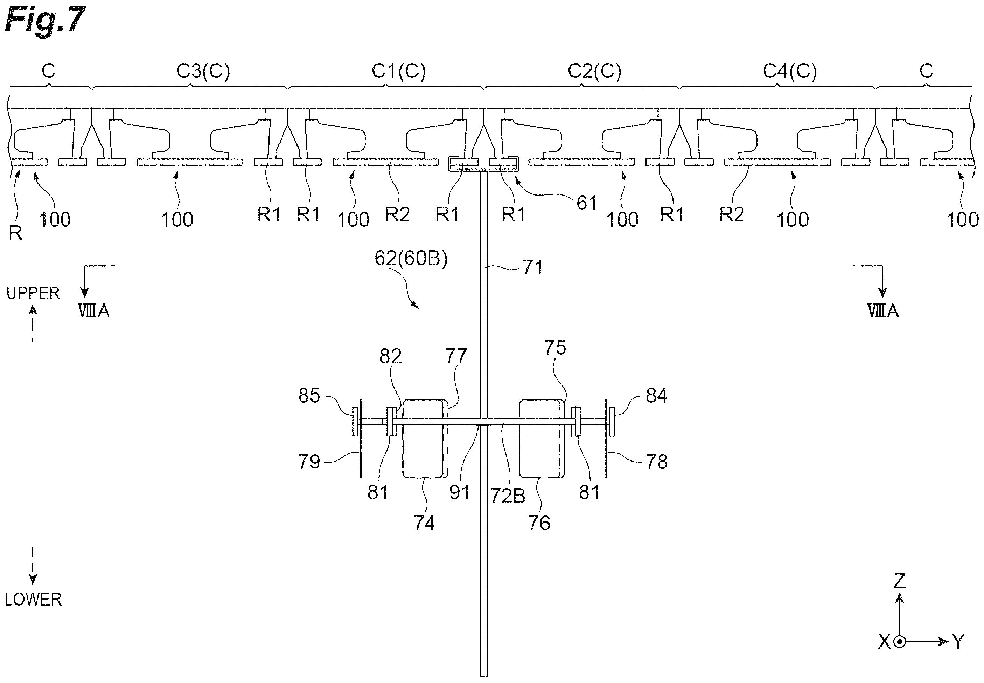

Further, as illustrated in FIGS. 7, 8(a), and 8(b), the first movable beam 72B and the second movable beam 73B are turned in the counterclockwise direction in plan view around the hinges 72C and 73C from the deployed state to bring the first movable beam 72B and the second movable beam 73B into the folded closed state, and thus, the body 62 can be deformed into the accommodated state (2-cell type). In the accommodated state, the obstacle sensor S1 of the overhead traveling vehicle 2 traveling along each of the first and second travel routes K1 and K2 passing through the first and second cells C1 and C2 can detect each of the inner stopper plates 74 and 75, and the obstacle sensor S1 of the overhead traveling vehicle 2 traveling along each of the third and fourth travel routes K3 and K4 passing through the third and fourth cells C3 and C4 cannot detect the outer stopper plates 76 and 77.

In addition, in the accommodated state, in a case where the overhead traveling vehicle 2 comes into contact with the body 62, the first dedicated pusher 81 presses the tape switch 12c of the overhead traveling vehicle 2, and the overhead traveling vehicle 2 can be urgently stopped. In the accommodated state, the first dual-purpose pusher 82 functions as a stopper, and the first movable beam 72B and the second movable beam 73B are prevented from turning in the counterclockwise direction in plan view more than necessary. In the accommodated state, the distal end portions of the first movable beam 72B and the second movable beam 73B protrude in the longitudinal direction from the distal end portion of the second fixed beam 73A and the distal end portion of the first fixed beam 72A.

A length of the first movable beam 72B is longer than a total length of the first fixed beam 72A, the connecting part 91, and the second fixed beam 73A in the left-right direction. A length of the second movable beam 73B is longer than the total length in the left-right direction. As a result, the distal end of the folded first movable beam 72B protrudes outward in the left-right direction from the hinge 73C. In the accommodated state, the first side stopper plate 78 is disposed at a position covering the hinge 73C provided between the second fixed beam 73A and the second movable beam 73B from a right side (the other side in the longitudinal direction) illustrated in FIGS. 7 and 8(a). In the accommodated state, the first side stopper plate 78 is detected by the obstacle sensor S1 of the overhead traveling vehicle 2 traveling toward the body 62 from the right side (the other side in the longitudinal direction). The distal end of the folded second movable beam 73B protrudes outward in the left-right direction from the hinge 72C. In the accommodated state, the second side stopper plate 79 is disposed at a position covering the hinge 72C provided between the first fixed beam 72A and the first movable beam 72B from a left side (one side in the longitudinal direction) illustrated in FIGS. 7 and 8(a). In the accommodated state, the second side stopper plate 79 is detected by the obstacle sensor S1 of the overhead traveling vehicle 2 traveling toward the body 62 from the left side. The first side stopper plate 78 and the second side stopper plate 79 are disposed at both end portions of the body 62 in the left-right direction. Four first detection target portions such as the pole 71 and the first inner stopper plate 74 are disposed between the first side stopper plate 78 and the second side stopper plate 79. In addition, in the accommodated state, in a case where the overhead traveling vehicle 2 comes into contact with the body 62, the second pusher 84 or the second pusher 85 presses the tape switch 12c of the overhead traveling vehicle 2, and thus, the overhead traveling vehicle 2 can be urgently stopped.

Even in the accommodated state of the body 62, the body 62 is made compact in the front-rear direction (transverse direction). That is, as illustrated in FIG. 9(b), in the transverse direction, the first detection target portions such as the pole 71 and the first inner stopper plate 74 fall within the range of the widths of the first side stopper plate 78 and the second side stopper plate 79. In addition, in the accommodated state of the body 62, the first fixed beam 72A, the second fixed beam 73A, the first movable beam 72B, and the second movable beam 73B fall within the range of the widths of the first side stopper plate 78 and the second side stopper plate 79 in the transverse direction.

Next, a usage example of the overhead traveling vehicle stopping device 60 will be described. First, for example, a user grips a lower end portion of the pole 71, and causes the engagement part 61 to enter the gap G between the first rail R1 and the intersection rail R3. As a result, the contact portion 61A of the engagement part 61 is located above the pair of first rails R1 and R1. In this state, after the pole 71 is moved along the first rail R1 such that the engagement part 61 is located at the central portion of the pair of first rails R1 and R1, the contact portion 61A is abutted and engaged with the upper surfaces of the pair of first rails R1 and R1, and the overhead traveling vehicle stopping device 60 is suspended on the pair of first rails R1 and R1.

Then, as illustrated in FIG. 10(a), for example, in a case where four parallel first to fourth travel routes K1 to K4 and the two first and second side travel routes K6 and K7 facing each other in the left-right direction are blocked, the first and second movable beams 72B and 73B are not folded, and the body 62 is brought into the deployed state. As a result, it is possible to stop the traveling of the overhead traveling vehicle 2 along the first to fourth travel routes and the traveling of the overhead traveling vehicle 2 along the first and second side travel routes K6 and K7. On the other hand, as illustrated in FIG. 10(b), for example, in a case where two parallel first and second travel routes K1 and K2 and two first and second side travel routes K6 and K7 facing each other in the left-right direction are blocked, the first and second movable beams 72B and 73B are folded, and the body 62 is brought into the accommodated state. As a result, the traveling of the overhead traveling vehicle 2 along the first and second travel routes K1 and K2 and the traveling of the overhead traveling vehicle 2 along the first and second side travel routes K6 and K7 can be stopped.

In a case where the body 62 is in the deployed state (see FIG. 3), the first side stopper plate 78 is detected by the obstacle sensor S1 of the overhead traveling vehicle 2 traveling along the first side travel route K6 (see FIG. 10(a)). The second side stopper plate 79 is detected by the obstacle sensor S1 of the overhead traveling vehicle 2 traveling along the second side travel route K7. In addition, in a case where the body 62 is in the accommodated state (see FIG. 7), the second side stopper plate 79 is detected by the obstacle sensor S1 of the overhead traveling vehicle 2 traveling along the first side travel route K6 (see FIG. 10(b)). The first side stopper plate 78 is detected by the obstacle sensor S1 of the overhead traveling vehicle 2 traveling along the second side travel route K7. The overhead traveling vehicle stopping device 60 is configured such that the disposition of the pair of left and right side stopper plates (second detection target portions) is switched between the deployed state and the accommodated state.

Next, a degree of freedom of layout in a case where the overhead traveling vehicle stopping device 60 of the present embodiment is used will be described. As described above, the overhead traveling vehicle stopping device 60 is deformable in both the deployed state (4-cell type) and the accommodated state (2-cell type). In the following description, for the sake of convenience, the stopping device in the deployed state is referred to as a 4-cell type stopping device 60A, and the stopping device in the accommodated state is referred to as a 2-cell type stopping device 60B.

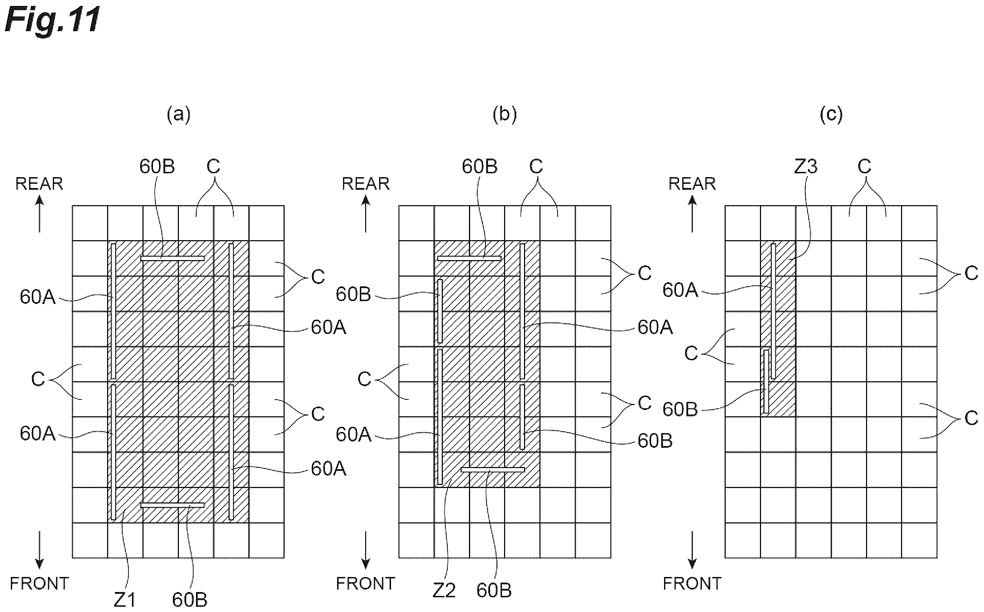

For example, in order to prohibit traveling in a region Z1 including 8 × 4 rows illustrated in FIG. 11(a), four 4-cell type stopping devices 60A and two 2-cell type stopping devices 60B can be installed. In order to prohibit traveling in a region Z2 including 7 × 3 rows illustrated in FIG. 11(b), two 4-cell type stopping devices 60A and four 2-cell type stopping devices 60B can be installed. In addition, in order to prohibit traveling in a region Z3 including 5 × 1 rows illustrated in FIG. 11(c), one 4-cell type stopping device 60A and one 2-cell type stopping device 60B can be installed. The 4-cell type stopping device 60A and the 2-cell type stopping device 60B may be installed such that the 4-cell type stopping device 60A and the 2-cell type stopping device 60B do not overlap each other in each cell C, or the 4-cell type stopping device 60A and the 2-cell type stopping device 60B may partially overlap each other in any one or a plurality of cells C (see FIG. 11(c)). In a case where the stopping devices overlap each other, the first outer stopper plate 76 or the second outer stopper plate 77 of the 4-cell type stopping device 60A is provided so as to overlap the first inner stopper plate 74 or the second inner stopper plate 75 of the 2-cell type stopping device 60B in the transverse direction. In addition, it is also possible to adopt an installation form in which a part of the 4-cell type stopping device 60A and a part of another 4-cell type stopping device 60A overlap each other in the transverse direction, and it is also possible to adopt an installation form in which a part of the 2-cell type stopping device 60B and a part of another 2-cell type stopping device 60B overlap each other in the transverse direction.

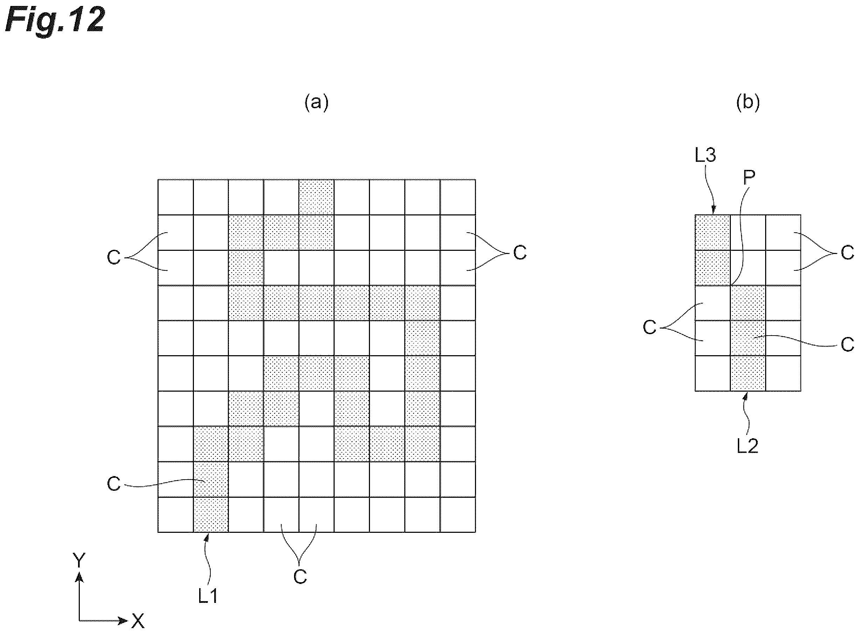

Next, an example in which a traveling prohibited region is set by forming a line segment by the overhead traveling vehicle stopping device 60 will be described. As illustrated in FIG. 12(a), a prohibition line L1, which is one line segment, is planned by connecting adjacent cells C. Note that, as illustrated in FIG. 12(b), a prohibition line L2 and a prohibition line L3 in an oblique positional relationship via a grid point P are considered to be separate line segments.

When the number of cells C on the prohibition line L1 is an even number, the prohibition line L1 can be constantly formed by the 2-cell type stopping device 60B (Item 1). When the number of cells C on the prohibition line L1 is an odd number, the prohibition line L1 can be constantly formed by the 2-cell type stopping device 60B by adopting the above-described overlapping installation form at any one place on the line segment (Item 2). In addition, in a closed region surrounded by one line segment, the number of cells C on the line segment is constantly an even number (Item 3). Accordingly, basically, any prohibition line and traveling prohibited region (or closed region) can be formed only by a plurality of 2-cell type stopping devices 60B. When the 2-cell type stopping device 60B is continuous on the straight line, this portion can be replaced with the 4-cell type stopping device 60A.

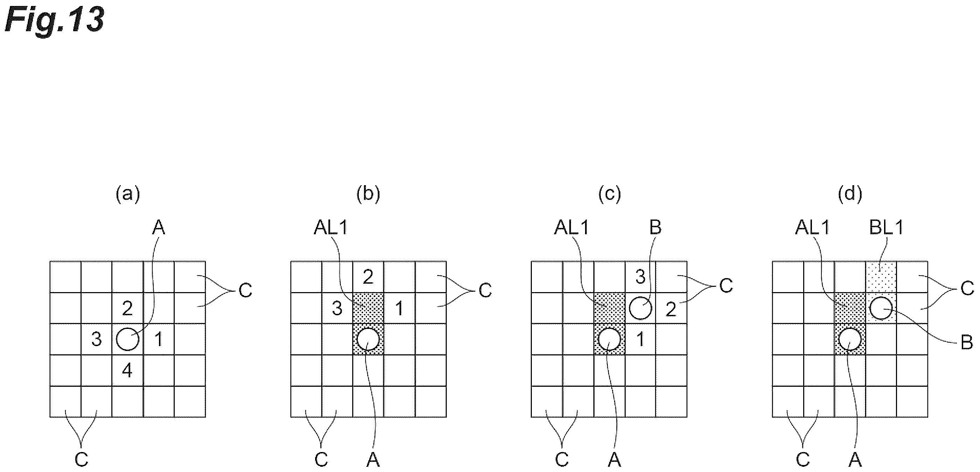

The above Item 1 will be described with reference to FIGS. 13(a) to 13(d). When a position of an end portion of the overhead traveling vehicle stopping device 60 is set as a starting point A (see FIG. 13(a)), any one of the first to fourth cells C in the drawing can be selected in order to create the line segment. Assuming that the second cell C in the drawing is selected, a partial line AL1 including two cells C is formed (see FIG. 13(b)). In order to further extend the line segment, any one of the first to third cells C in the drawing can be selected. Assuming that the first cell C in the drawing is selected, a starting point B becomes a position of an end portion of a new overhead traveling vehicle stopping device 60 (see FIG. 13(c)). In order to further extend the line segment, any one of the first to third cells C in the drawing can be selected. Assuming that the third cell C in the drawing is selected, a partial line BL1 including two cells C is formed (see FIG. 13(d)). These steps are repeated, and thus, the 2-cell type stopping device 60B can form the prohibition line L1.

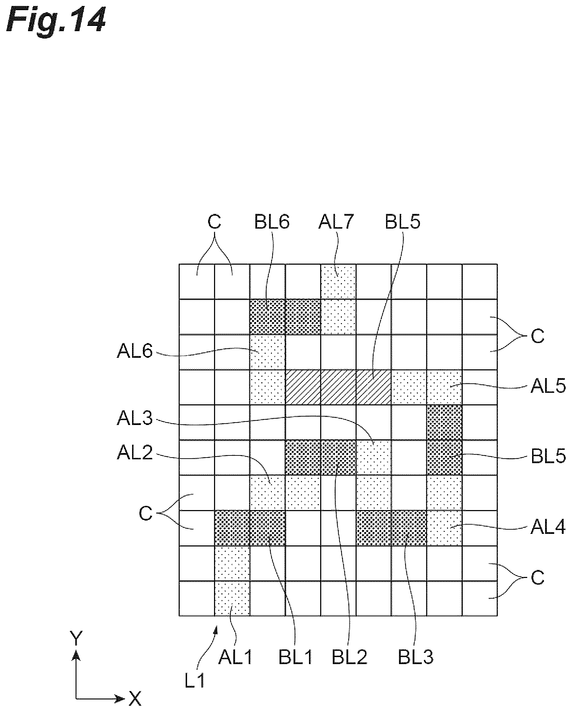

The above Item 2 will be described with reference to FIG. 14. As illustrated in FIG. 14, in order to form the prohibition line L1, for example, the partial line AL1, the partial line BL1, a partial line AL2, a partial line BL2, a partial line AL3, a partial line BL3, a partial line AL4, a partial line BL4, a partial line AL5, a partial line BL5, a partial line AL6, a partial line BL6, and a partial line AL7 can be sequentially set. Only the partial line BL5 includes three cells C, and the other partial lines all include two cells C. In this case, the above-described overlapping installation form may be adopted at a starting end portion or a terminating end portion of the partial line BL5.

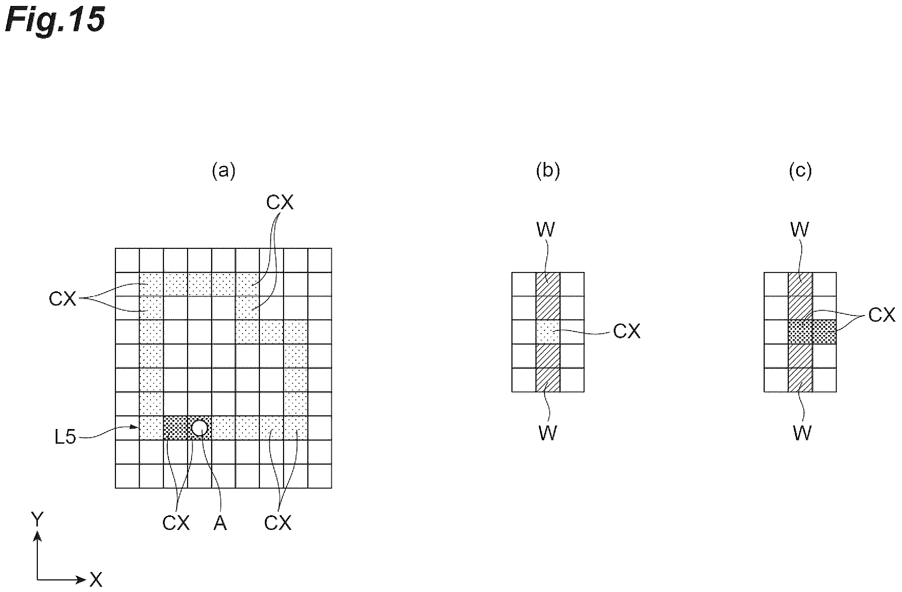

The above Item 3 will be described with reference to FIGS. 15(a) to 15(c). As illustrated in FIG. 15(a), two prohibited cells CX are densely hatched as marks for description. Starting from the starting point A (a point constituting one of the two prohibited cells CX) in the drawing and returning to a front position (a point constituting the other of the two prohibited cells CX), the prohibition line L5 forms a closed region. In order to return to the same position, in both the X direction and the Y direction, the stopping device returns by the amount of advance. Since the number of advanced prohibited cells CX and the number of returned prohibited cells CX are the same, the number of prohibited cells CX constituting the prohibition line L5 is constantly an even number.

Note that, as illustrated in FIG. 15(b), in a case where it is necessary to close one prohibited cell CX sandwiched between two wall portions W and W, as illustrated in FIG. 15(c), two prohibited cells CX may be set, and the 2-cell type stopping device 60B may be installed in the two prohibited cells CX.

According to the overhead traveling vehicle stopping device 60 and the traveling vehicle system 1, the engagement part 61 is engaged with the first rail R1 or the like, and thus, in a case where the overhead traveling vehicle 2 travels along the transverse direction of the body 62, the first inner stopper plate 74 or the like is detected by the obstacle sensor S1 of the overhead traveling vehicle 2 and the traveling is stopped. In a case where the overhead traveling vehicle 2 travels along the longitudinal direction of the body 62, the first side stopper plate 78 or the like is detected by the obstacle sensor S1 of the overhead traveling vehicle and the traveling is stopped. As described above, it is possible to appropriately prohibit the overhead traveling vehicle 2 from entering from two different directions (a plurality of directions) without preparing and attaching the plurality of stopping devices.

The "transverse direction" which is a stop direction by the first detection target portion and the "longitudinal direction" which is a stop direction by the second detection target portion are orthogonal to each other in the horizontal plane. As a result, in a case where travel routes in two directions orthogonal to each other are set by the first rail R1 and the second rail R2, it is possible to appropriately prohibit the overhead traveling vehicle 2 from entering from these two directions by using an end surface of the body 62 in the longitudinal direction. The overhead traveling vehicle stopping device 60 is suitable for a grid-shaped track such as a so-called grid system.

In the overhead traveling vehicle stopping device 60, the first detection target portions such as the pole 71 and the first inner stopper plate 74 are accommodated within the range of the widths of the first side stopper plate 78 and the second side stopper plate 79 in the transverse direction. As a result, the body 62 can have a simple configuration. In addition, the device can be made slim in the transverse direction.

By the first dedicated pusher 81, the first dual-purpose pusher 82, the second pusher 84, or the second pusher 85, it is possible to forcibly stop the overhead traveling vehicle 2 by turning off the power supply of the overhead traveling vehicle 2 coming into contact with the body 62.

The first detection target portion such as the first inner stopper plate 74 is disposed between the second pusher 84 and the second pusher 85. As a result, it is possible to appropriately prohibit the overhead traveling vehicle 2 from entering from one side in the longitudinal direction and the overhead traveling vehicle 2 from the other side in the longitudinal direction.

By the first inner stopper plate 74 and the second inner stopper plate 75, and the first outer stopper plate 76 and the second outer stopper plate 77, it is possible to cause the overhead traveling vehicle stopping device 60 to prohibit passage through each of the four parallel travel routes in a so-called grid system.

The overhead traveling vehicle stopping device 60 is deformable between a deployed state where the obstacle sensor S1 of the overhead traveling vehicle 2 traveling along the first outer travel route K3 or the second outer travel route K4 can detect the first outer stopper plate 76 and the second outer stopper plate 77 and an accommodated state where the obstacle sensor S1 of the overhead traveling vehicle 2 traveling along the first outer travel route K3 or the second outer travel route K4 cannot detect the first outer stopper plate 76 and the second outer stopper plate 77. As a result, it is possible to easily adjust a place where passage of the overhead traveling vehicle is prohibited.

The first inner stopper plate 74 and the second inner stopper plate 75 are provided on the first fixed beam 72A and the second fixed beam 73A, and the first outer stopper plate 76 and the second outer stopper plate 77 are provided on the first movable beam 72B and the second movable beam 73B. As a result, the overhead traveling vehicle stopping device 60 can be easily deformed into the accommodated state by folding the first movable beam 72B and the second movable beam 73B. The compact overhead traveling vehicle stopping device 60 is realized only by folding in a Z shape in plan view.

Each of the first movable beam 72B and the second movable beam 73B turns around the hinge 72C and the hinge 73C in the counterclockwise direction in plan view. In both the deployed state and the accommodated state of the body 62, the first fixed beam 72A, the second fixed beam 73A, the first movable beam 72B, and the second movable beam 73B are within the range of the widths of the first side stopper plate 78 and the second side stopper plate 79 in the transverse direction. Since the first movable beam 72B and the second movable beam 73B have the same rotation direction, the overhead traveling vehicle stopping device 60 can be easily deformed (folded). In both the deployed state and the accommodated state, the compact overhead traveling vehicle stopping device 60 is realized.

Although the embodiment has been described above, one aspect of the present invention is not limited to the above embodiment, and various modifications can be made without departing from the gist of the invention.

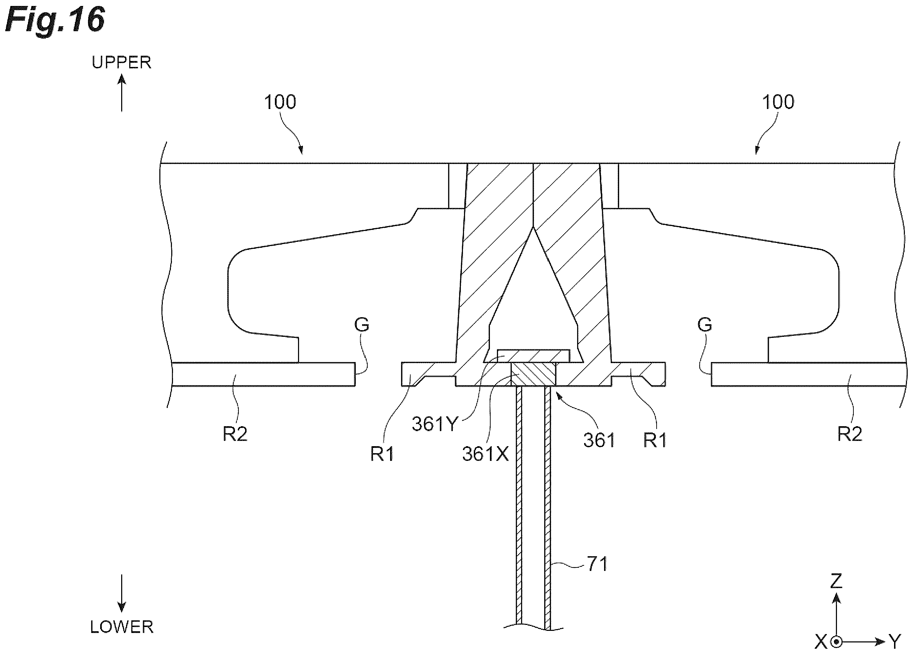

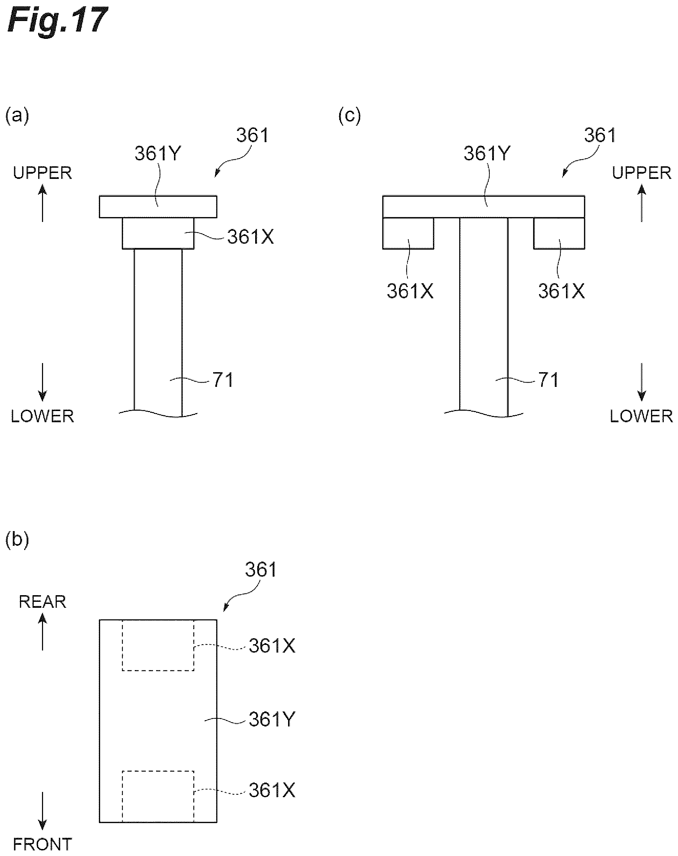

In the above embodiment, although the engagement part 61 of the C-shaped hook is adopted, an aspect of the engagement part 61 is not particularly limited. For example, an engagement part 361 of a T-shaped hook illustrated in FIGS. 16, 17(a), 17(b), and 17(c) may be adopted. The engagement part 361 is engaged with the pair of first rails R1 and R1 extending along the same direction and aligned to approach to each other. The engagement part 361 includes an insertion part 361X inserted between the pair of first rails R1 and R1, and contact portions 361Y connected to an upper side of the insertion part 361X and abutting on the upper surfaces of the pair of first rails R1 and R1. The insertion part 361X is a member having a rectangular parallelepiped shape. The contact portion 361Y is a rectangular plate-shaped member. The insertion parts 361X are provided at both end portions of a lower surface of the contact portion 361Y in the longitudinal direction. An upper end of the pole 71 is fixed to a central portion of the lower surface of the contact portion 361Y. The axial direction of the pole 71 is orthogonal to the lower surface of the contact portion 361Y.

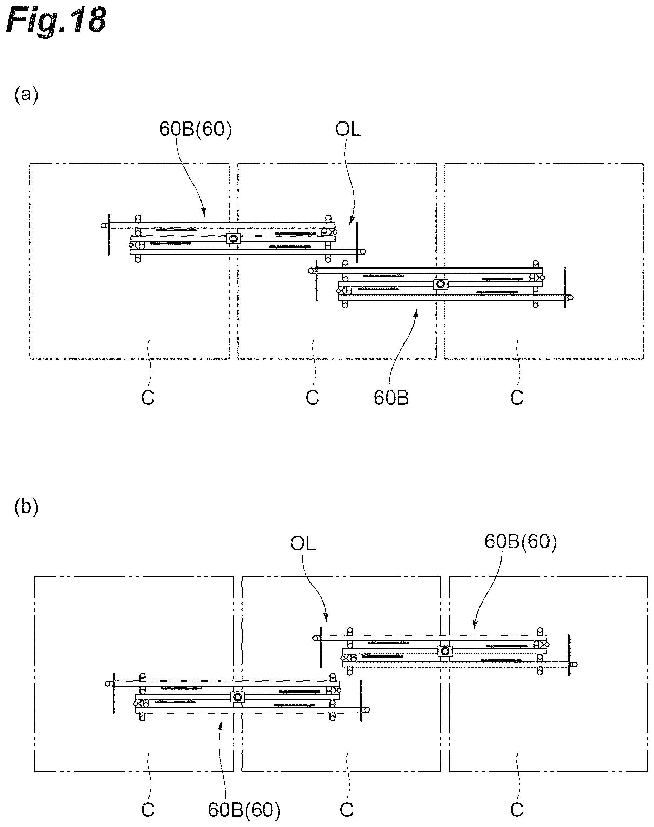

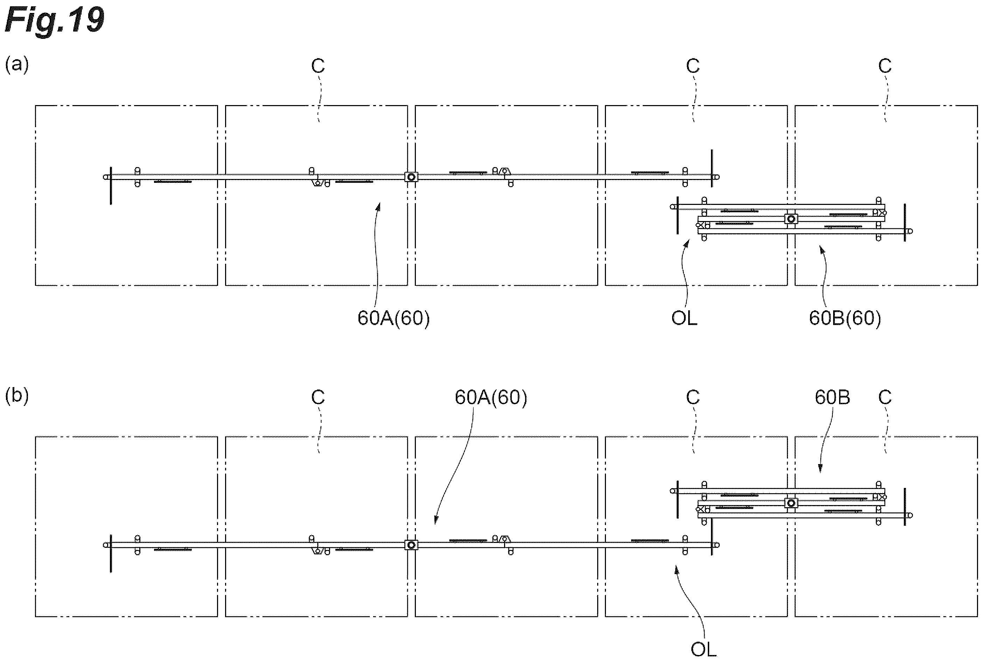

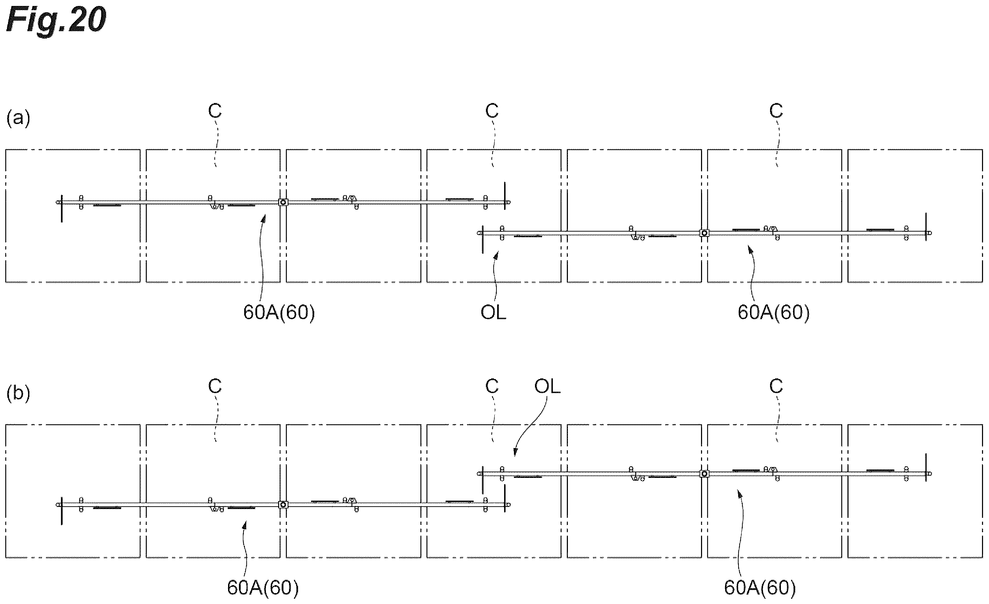

The overhead traveling vehicle stopping device 60 may be installed such that the above insertion parts 361X are brought into contact with a cell connecting bracket that connects the first rails R1 and R1 or the second rails R2 and R2. This installation method is useful in a case where the overhead traveling vehicle stopping device 60 is installed for an odd number of prohibited cells CX. For example, in a case where the number of prohibited cells CX is three, as illustrated in FIGS. 18(a) and 18(b), two 2-cell type stopping devices 60B may be installed by providing one overlapping portion OL. In addition, in a case where the number of prohibited cells CX is 5, as illustrated in FIGS. 19(a) and 19(b), one 4-cell type stopping device 60A and one 2-cell type stopping device 60B may be installed by providing one overlapping portion OL. In addition, in a case where the number of prohibited cells CX is 7, as illustrated in FIGS. 20(a) and 20(b), two 4-cell type stopping devices 60A may be installed by providing one overlapping portion OL.

In the above embodiment or modification, although the overhead traveling vehicle stopping device 60 can block the four parallel first to fourth travel routes K1 to K4 and the two first and second side travel routes K6 and K7, the present invention is not limited thereto. The overhead traveling vehicle stopping device may be able to block one or a plurality of parallel travel routes extending in the transverse direction and one or a plurality of travel routes extending in the longitudinal direction. For example, the overhead traveling vehicle stopping device may have only the first fixed beam and the second fixed beam as the arm members in the horizontal direction and be able to block the two parallel first and second travel routes K1 and K2. In this overhead traveling vehicle stopping device, deformation such as folding is not performed, and the stopping device corresponds to the two cells C. The second detection target portions similar to the first side stopper plate 78 and the second side stopper plate 79 are provided at the distal end of the first fixed beam and/or the second fixed beam.

In the above embodiment or modification, the layout of the first rail R1, the second rail R2, and the intersection rail R3 is not particularly limited, and various layouts may be adopted. In the above embodiment or modification, although the engagement part 61 is engaged with the pair of first rails R1 and R1 aligned so as to approach or come into contact with each other, the present invention is not limited thereto. For example, the engagement part according to one aspect may be engaged with the pair of second rails R2 aligned so as to approach or come into contact with each other, may be engaged with the intersection rail R3, or may be engaged with one first rail R1 or second rail R2.

In the above embodiment or modification, although the first detection target portions are the stopper plates 74 to 77 and the second detection target portions are the stopper plates 78 and 79, the present invention is not limited thereto. The first detection target portion and/or the second detection target portion may be, for example, a block-shaped object. In the above embodiment or modification, although the circular tubular member is used as the pusher, the shape of the pusher is not limited, and may be various shapes.

Each of the first movable beam 72B and the second movable beam 73B may turn around the hinge 72C and the hinge 73C in the clockwise direction in plan view. The folding structure in the body 62 may not be the Z-shaped structure as in the above embodiment. The body may not include the arm member such as the fixed beam or the movable beam described above, and may have, for example, a rectangular box shape or a block shape as a whole. In this case, the body may include one or a plurality of frame members.

In the above embodiment or modification, although both the first side stopper plate and the second side stopper plate are provided as the second detection target portions, either one of the first side stopper plate 78 and the second side stopper plate 79 may be omitted, and the overhead traveling vehicle stopping device may include only one second detection target portion.

The "transverse direction" which is the stop direction by the first detection target portion and the "longitudinal direction (another direction)" which is the stop direction by the second detection target portion may intersect at an angle other than 90 degrees. The "transverse direction" and the "longitudinal direction (another direction)" may intersect at an acute angle.

In the above embodiment or modification, although the grid-shaped track R is formed by suspending the plurality of rail units 100 on the ceiling while connecting the rail units, the present invention is not limited thereto. For example, the first rail R1, the second rail R2, and the intersection rail R3 may be directly suspended on the ceiling by a hanging member or the like without being unitized.

In the above embodiment or modification, in the overhead traveling vehicle stopping device 60, at least the first and second travel routes corresponding to the rails (here, the pair of first rails R1 and R1) with which the engagement part 61 is engaged are prohibited from passing, the present invention is not limited thereto. For example, a travel route that does not correspond to the first rail R1 or the second rail R2 with which the engagement part 61 is engaged may be prohibited from passing.

In the above embodiment or modification, although the grid system is adopted as the traveling vehicle system 1, the traveling vehicle system 1 is not limited to the grid system. The traveling vehicle system may include a one-way rail provided in advance for traveling of the overhead traveling vehicle. In this case, for example, the overhead traveling vehicle stopping device is attached to a one-way first rail or a one-way second rail parallel to the first rail, and stops the traveling of the overhead traveling vehicle along the first and second travel routes constituted by the first and second rails.

Each configuration in the above embodiment or modification can be voluntarily applied to each configuration in another embodiment or modification. A part of each configuration in the above embodiment or modification can be appropriately omitted without departing from the gist of one aspect of the present invention. The present invention is not limited to the above embodiment, and various modifications can be made without departing from the gist of the invention.

### Reference Signs List

1 Traveling vehicle system
2 Overhead traveling vehicle
12c Tape switch (power switch)
60, 360 Overhead traveling vehicle stopping device
61, 361 Engagement part
62 Body
71 Pole (elongated member)
72A First fixed beam (proximal arm member)
72B First movable beam (distal arm member)
72C Hinge
73A Second fixed beam (proximal arm member)
73B Second movable beam (distal arm member)
73C Hinge
74 First inner stopper plate (inner detection target portion, first detection target portion)
75 Second inner stopper plate (inner detection target portion, first detection target portion)
76 First outer stopper plate (outer detection target portion, first detection target portion)
77 Second outer stopper plate (outer detection target portion, first detection target portion)
78 First side stopper plate (second detection target portion)
79 Second side stopper plate (another second detection target portion)
81 First dedicated pusher (first push-down part)
82 First dual-purpose pusher (first push-down part)
84 Second pusher (second push-down part)
85 Second pusher (another second push-down part)
91 Connecting part
361X Insertion part
361Y Contact portion
C Cell
G Gap
K1 First inner travel route
K2 Second inner travel route
K3 First outer travel route
K4 Second outer travel route
K6 First side travel route
K7 Seventh lateral travel route
R Grid-shaped track (rail)
R1 First rail (first straight rail, straight rail)
R2 Second rail (second straight rail, straight rail)
R3 Intersection rail
S1 Obstacle sensor.

## Claims

1. An overhead traveling vehicle stopping device attached to rails provided on a ceiling and configured to stop an overhead traveling vehicle traveling along travel routes constituted by the rails, the overhead traveling vehicle stopping device comprising:
an engagement part configured to be engageable with the rail; and
a body that includes an elongated member configured to extend downwardly from the engagement part, wherein
the body includes
at least one first detection target portion configured to be detected by obstacle sensors of the overhead traveling vehicle traveling toward the body from a transverse direction intersecting the elongated member, and
a second detection target portion configured to be detected by the obstacle sensor of the overhead traveling vehicle traveling toward the body from another direction intersecting the elongated member and different from the transverse direction.

2. The overhead traveling vehicle stopping device according to claim 1, wherein the transverse direction and the other direction are orthogonal to each other in a horizontal plane.

3. The overhead traveling vehicle stopping device according to claim 1 or 2, wherein
the elongated member has a rod shape,
the second detection target portion has a plate shape with the other direction as a thickness direction, and
the elongated member and the first detection target portion are accommodated within a range of a width of the second detection target portion in the transverse direction.

4. The overhead traveling vehicle stopping device according to claim 1 or 2, wherein
the body includes
a first push-down part configured to press down a power switch of the overhead traveling vehicle in a case where the first push-down part comes into contact with the overhead traveling vehicle approaching from the transverse direction, and
a second push-down part configured to press down the power switch of the overhead traveling vehicle in a case where the second push-down part comes into contact with the overhead traveling vehicle approaching from the other direction.

5. The overhead traveling vehicle stopping device according to claim 1 or 2, wherein
the body includes
the second detection target portion detected by the obstacle sensor of the overhead traveling vehicle traveling toward the body from one side in the other direction, and
another second detection target portion detected by the obstacle sensor of the overhead traveling vehicle traveling toward the body from the other side in the other direction, and
the first detection target portion is disposed between the second detection target portion and the other second detection target portion.

6. The overhead traveling vehicle stopping device according to claim 1 or 2, wherein
the at least one first detection target portion includes
two inner detection target portions, respectively, detected by the obstacle sensors of the overhead traveling vehicle traveling along two parallel inner travel routes that are the travel routes extending in the transverse direction, and
two outer detection target portions, respectively, detected by the obstacle sensors of the overhead traveling vehicle traveling along two outer travel routes located on both sides of the two inner travel routes in the other direction and parallel to the two inner travel routes.

7. The overhead traveling vehicle stopping device according to claim 6, wherein the body is deformable between a deployed state where the obstacle sensors of the overhead traveling vehicle traveling along the two outer travel routes are capable of detecting the two outer detection target portions, respectively,and an accommodated state where the obstacle sensors of the overhead traveling vehicle traveling along the two outer travel routes are not capable of detecting the two outer detection target portions.

8. The overhead traveling vehicle stopping device according to claim 7, wherein
the body includes a pair of proximal arm members extending from the elongated member along a longitudinal direction that is the other direction, and a pair of distal arm members foldably connected to distal ends of the proximal arm members via hinges,
the two inner detection target portions are provided on the pair of proximal arm members, and
the two outer detection target portions are provided on the pair of distal arm members.

9. The overhead traveling vehicle stopping device according to claim 8, wherein
each of the pair of distal arm members rotates about the hinge in one of a clockwise direction and a counterclockwise direction in plan view, and
in both the deployed state and the accommodated state of the body, the pair of proximal arm members and the pair of distal arm members fall within a range of a width of the second detection target portion in the transverse direction.

10. A traveling vehicle system comprising:
rails that are provided on a ceiling, at least a part of the rails being disposed in a grid shape;
an overhead traveling vehicle configured to travel along travel routes constituted by the rails; and
the overhead traveling vehicle stopping device according to claim 1 or 2 configured to stop the overhead traveling vehicle traveling along the travel route.

11. The traveling vehicle system according to claim 10, wherein
the rails include a plurality of first straight rails extending in a first direction that is a horizontal direction, and a plurality of second straight rails extending in a second direction that is a horizontal direction orthogonal to the first direction, and
in a case where a rectangular region surrounded by a pair of the first straight rails and a pair of the second straight rails in plan view is defined as one cell,
the at least one first detection target portion includes
two inner detection target portions, respectively, detected by the obstacle sensors of the overhead traveling vehicle traveling along two parallel inner travel routes that are the travel routes passing through two central cells among four cells arranged in a line, and
two outer detection target portions, respectively, detected by the obstacle sensors of the overhead traveling vehicle traveling along two outer travel routes that are the travel routes passing through two cells at both ends among the four cells and are parallel to the inner travel routes.

12. The traveling vehicle system according to claim 11, wherein the body is deformable between a deployed state where the obstacle sensors of the overhead traveling vehicle traveling along the two outer travel routes are capable of detecting the two outer detection target portions, and an accommodated state where the obstacle sensors of the overhead traveling vehicle traveling along the two outer travel routes are not capable of detecting the two outer detection target portions.

13. The traveling vehicle system according to claim 10, wherein
the rails include
a plurality of straight rails, and
intersection rails disposed so as to be adjacent to end portions of the straight rails in a horizontal direction with a gap therebetween,
the engagement part
is engaged with a pair of the straight rails extending along a same direction and aligned so as to approach or come into contact with each other,
is capable of passing through the gap in a vertical direction, and
has a C-shape opened upward as viewed from a direction along the pair of straight rails, and
includes a contact portion that comes into contact with an upper surface of each of the pair of straight rails.

14. The traveling vehicle system according to claim 10, wherein
the rails include a plurality of straight rails, and
the engagement part
is engaged with a pair of the straight rails extending along a same direction and aligned so as to approach to each other, and
includes an insertion part that is inserted between the pair of straight rails, and a contact portion that is connected to an upper side of the insertion part and comes into contact with an upper surface of each of the pair of straight rails.
